# EUROPEAN PATENT APPLICATION

(11) **EP 3 276 693 A1**
(43) Date of publication of application: **31.01.2018**
(21) Application number: 16181686.3
(22) Date of filing: 28.07.2016
(51) Int. Cl.: H01L 51/42

(54) **SOLAR CELLS WITH CONDUCTIVE POLYMER PASSIVATION LAYERS ON THE BACK SIDE**

(71) Applicant: Heraeus Deutschland GmbH & Co. KG, 63450 Hanau (DE)
(72) Inventor: Sauer, Rüdiger, 51373 Leverkusen (DE); Lövenich, Wilfried, 51469 Bergisch Gladbach (DE); Sautter, Armin, 40593 Düsseldorf (DE)
(74) Representative: Herzog, Fiesser & Partner Patentanwälte PartG mbB

(57) **Abstract**

The present invention relates to a solar cell (1) comprising
i) a substrate (2) of p-type silicon or n-type silicon, wherein the substrate (2) comprises a front side (2a) the surface of which is at least partially covered with at least one passivation layer (3) and a back side (2b);
ii) a conductive polymer layer (4) that at least partially covers the back side (2b) of the substrate; and
iii) an electrode (5) that at least partially covers the conductive polymer layer (4) one the side of the conductive polymer layer (4) that is facing away from the substrate (5).

The present invention also relates to a process for the preparation of a solar cell, to a solar cell obtainable by this process and to a solar module.

## Description

### FIELD OF THE INVENTION

The present invention relates to a solar cell, a process for the preparation of a solar cell, to a solar cell obtainable by this process and to a solar module.

### BACKGROUND OF THE INVENTION

Solar cells are devices that convert the energy of light into electricity using the photovoltaic effect. Solar power is an attractive green energy source because it is sustainable and produces only non-polluting by-products. Accordingly, a great deal of research is currently being devoted to developing solar cells with enhanced efficiency while continuously lowering material and manufacturing costs. When light hits a solar cell, a fraction of the incident light is reflected by the surface and the remainder transmitted into the solar cell. The transmitted photons are absorbed by the solar cell, which is usually made of a semiconducting material, such as silicon which is often doped appropriately. The absorbed photon energy excites electrons of the semiconducting material, generating electron-hole pairs. These electron-hole pairs are then separated by p-n junctions and collected by conductive electrodes on the solar cell surfaces.

Solar cells are very commonly based on silicon, often in the form of a Si wafer. Here, a p-n junction is commonly prepared either by providing an n-type doped Si substrate and applying a p-type doped layer to one face or by providing a p-type doped Si substrate and applying an n-type doped layer to one face to give in both cases a so called p-n junction. Both n-type and p-type solar cells are possible and have been exploited industrially.

In order to achieve high efficiencies in solar cells it is necessary to minimize recombination losses in the solar cell. Here a distinction must be made between (i) recombination in the crystalline silicon wafer, (ii) the recombination at the non-metallized surfaces of the solar cell which can be passivated with dielectric layers such as SiO₂ SiNₓ or Al₂O₃, and (iii) the recombination at the metal-semiconductor junctions of the solar cell.

The high recombination at the metallized surface of a Si solar cell will more and more dominate the total loss of recombination as the passivation of not metallized areas with dielectric layers such as SiO₂, SiNₓ or Al₂O₃ increasingly finds its way into the production of solar cells. In order to approach the technologically feasible limit of the solar cell efficiency (about 25 %) it is essential to effectively reduce the recombination at the metal/semiconductor interfaces of the solar cell while avoiding that the contact resistance is not increased to an inacceptable extend.

In the last few years heterojunctions with amorphous silicon (a-Si) have proven to be an effective way of reducing the recombination at the metal/semiconductor interfaces. The deposition of the a-Si layer is usually effected by means of plasma enhanced chemical vapor deposition ("*Plasma Enhanced Chemical Vapor Deposition*", PECVD) using silane, hydrogen and diborane for the deposition of a p-type layer [a-Si (p)] or phosphine for the deposition of an n-type layer [a-Si (n)]. To achieve the required throughput by means of the a-Si/c-Si-heterojunction technology relatively thin a-Si layers are deposited by means of PECVD, resulting in an insufficient lateral conductivity. In order to reduce the layer resistance a transparent conductive layer such as an indium tin oxide (ITO) layer, is deposited on the a-Si layer. In view of the high efficiency potential of a-Si/c-Si-heterojunctions this solar cell technology is considered by many experts to be a realistic option for the next generation of industrial solar cells with efficiencies above 23 %.

However, the disadvantage in this approach has to be seen in the fact that, as an ITO-layer has to be deposited to reduce the sheet resistance, the material costs are quite high and the use of rare metals such as indium in solar cells is generally problematic, especially in the long term. Furthermore, gases such as phosphine or diborane are used for the doping of the a-Si layers and these gases are known and feared as being extremely dangerous poison gases.

A further approach for reducing the recombination at the metal/semiconductor interfaces of the solar cell is the use of Si/organic heterojunctions. Organic-silicon hybrid solar cells composed of an n-type crystalline silicon base and an organic poly(3,4-ethylenedioxythiophene) : poly(styrenesulfonate) (PEDOT/PSS) hole-conducting emitter layer provide a unique possibility to combine the high energy conversion efficiencies of crystalline silicon solar cells with the potentially low fabrication cost of organic solar cells. Schmidt et al. ("Organic-silicon heterojunction solar cells: Open-circuit voltage potential and stability"; Appl. Phys. Lett. 103, 183901 (2013)) have characterized the electronic properties of crystalline silicon (c-Si)/(PEDOT/PSS) junctions by means of contactless carrier lifetime measurements on silicon wafers and fabricated a solar cell in which the (c-Si)/(PEDOT/PSS) junction was localized at the textured front side.

However, the approach disclosed by Schmidt *et al.* (i. e. the application of PEDOT/PSS on the front side of the silicon solar cell) is characterized by several disadvantages. First of all, the PEDOT/PSS-layer on the solar cell front side is characterized by a strong parasitic absorption, which limits the short-circuit current of this cell type. Moreover, the refractive index of the PEDOT/PSS-layer is not optimal so that the PEDOT/PSS layer cannot serve as a good anti-reflective layer (compared to, for example, anti-reflective layers based on SiNₓ). Also, the contact resistance of the PEDOT/PSS layer is comparatively high and the stability of the solar cell disclosed by Schmidt *et al.* in humid air and towards UV-radiation is insufficient.

WO 2015/140145 A1 discloses solar cell comprising a substrate of p-type silicon or n-type silicon, wherein the back side of the substrate is at least partially covered with a passivation layer having a thickness sufficient to allow a transport of holes through it, wherein the passivation layer on the back side of the substrate is at least partially covered with a conductive polymer layer. As the back side electrode a metal containing layer is directly applied onto the conductive polymer layer, wherein the back side electrode is preferably a silver layer that has been applied by means of electron beam evaporation.

### SUMMARY OF THE INVENTION

The present invention is generally based on the object of overcoming at least one of the problems encountered in the state of the art in relation to solar cells.

More specifically, the present invention is further based on the object of providing solar cells with high efficiencies in which losses through recombination at the metal/semiconductor interfaces are reduced and which can be produced in a simple and cost effective manner, without applying high vacuum process steps for the back-side processing. Compared to solar cells known in the prior art that have been prepared for that purpose the solar cells according to the present invention should be characterized by an improved stability when being stored in a humid atmosphere and/or an improved stability towards UV-radiation.

A contribution to achieving at least one of the above described objects is made by the subject matter of the category forming claims of the present invention. A further contribution is made by the subject matter of the dependent claims which represent specific embodiments of the invention.

### EMBODIMENTS

|1| A solar cell at least comprising
   i) a substrate of p-type silicon or n-type silicon, wherein the substrate comprises a front side the surface of which is at least partially covered with at least one passivation layer and a back side;
   ii) a conductive polymer layer that at least partially covers the back side of the substrate;
   iii) an electrode that at least partially covers the conductive polymer layer on the side of the conductive polymer layer that is facing away from the substrate;
      wherein the electrode
   iiia) is a conductive metal layer that is attached to at least a part of the surface of the conductive polymer layer by means of a conductive adhesive layer, wherein preferably the conductive adhesive layer has a conductivity of not more than 1000 S/cm , more preferably not more than 100 S/cm and even more preferably not more than 10 S/cm;
      or
   iiib) is a conductive layer that has been prepared by applying a liquid composition comprising conductive metal particles onto at least a part of the surface of the conductive polymer layer, wherein preferably the liquid composition is subsequently hardened, more preferably hardened by drying or curing, to form the conductive layer.
|2| A solar cell at least comprising
   i) a substrate of p-type silicon or n-type silicon, wherein the substrate comprises a front side the surface of which is at least partially covered with at least one passivation layer and a back side;
   ii) a conductive polymer layer that at least partially covers the back side of the substrate;
   iii) an electrode that at least partially covers the conductive polymer layer on the side of the conductive polymer layer that is facing away from the substrate;
      wherein at least a part of the lateral surfaces of the solar cell is covered by protective film.
|3| The solar cell according to embodiment |1|, wherein the conductive metal layer is a metal foil that comprises one or more metals selected from the group consisting of copper, aluminum, tin, iron, nickel, silver, gold, lead, zinc, cobalt, chromium, titanium, and a mixtures of at least two of these metals.
|4| The solar cell according to embodiment |2|, wherein the metal foil is a surface passivated metal foil.
|5| The solar cell according to anyone of embodiments |1| and |3| to |4|, wherein the conductive adhesive layer has a conductivity of at least 0.5 S/cm, preferably of at least 1 S/cm.
|6| The solar cell according to anyone of embodiments |1| and |3| to |5|, wherein the conductive adhesive layer comprises less than 35000 ppm, preferably less than 20000 ppm and more preferably less than 1000 ppm of nitrogen, in each case based on the total weight of the adhesive layer.
|7| The solar cell according to anyone of embodiments |1| and |3| to |6|, wherein the conductive adhesive layer comprises organic conductive particles, inorganic conductive particle or a mixture thereof.
|8| The solar cell according to embodiment |7|, wherein inorganic conductive particles are carbon-based particles or metal nano particles.
|9| The solar cell according to embodiment |8|, wherein the carbon-based particles are graphite particles.
|10| The solar cell according to embodiment |7|, wherein the organic particles are particles comprising a polythiophene/polymeric anion-complex, preferably a PEDOT/PSS-complex.
|11| The solar cell according to anyone of embodiments |1| and |3| to |10|, wherein the conductive adhesive layer has a thickness of less than 40 µm.
|12| The solar cell according to anyone of embodiments |1| and |3| to |11|, wherein the solar cell comprises a further conductive layer that comprises metal nanowires.
|13| The solar cell according to embodiment |12|, wherein the metal nanowires are silver nanowires.
|14| The solar cell according to embodiment |12| or |13|, wherein the further conductive layer is arranged between the conductive polymer layer that at least partially covers the back side of the substrate, and the adhesive layer.
|15| The solar cell according to anyone of embodiments |12| to |14|, wherein the further conductive layer is a PEDOT/PSS-layer that comprises silver nanowires.
|16| The solar cell according to embodiment |14| or |15|, wherein the content of metal nanowires in the further conductive layer is in the range from 15 to 70 wt.-%, based on the total weight of the further conductive layer.
|17| The solar cell according to embodiment |15| or |16|, wherein the thickness of the further conductive layer is in the range from 60 to 500 nm.
|18| The solar cell according to anyone of embodiments |1| and |3| to |18|, wherein at least a part of the lateral surfaces of the solar cell is covered by protective film.
|19| The solar cell according to embodiment |2| or |18|, wherein the protective film is a layer of an epoxy resin that at least partially covers the lateral surfaces of the solar cell.
|20| The solar cell according to embodiment |18| or |19|, wherein a layer of an adhesive polymer tape is arranged between the lateral surfaces of the solar cell and the protective film.
|21| The solar cell according to anyone of the preceding embodiments, wherein at least one of the following conditions a) and b) is fulfilled:
   a) the conductive polymer layer is at least partially in direct contact with the surface of the p-type or n-type silicon;
   b) the conductive polymer layer comprises a cationic conductive polymer and a polymeric anion in a weight ratio cationic conductive polymer : polymeric anion of greater than 0.4.
|22| The solar cell according to anyone of the preceding embodiments, wherein the at least one passivation layer is selected from the group consisting of a silicon nitride layer (SiNₓ), a silicon oxide layer (SiOₓ), a silicon carbide layer (SiC), a titanium oxide layer (TiOₓ), an aluminium oxide layer (AlOₓ), a layer of amorphous silicon (a-Si) or a layer stack comprising of an intrinsic undoped amorphous silicon layer (a-Si (i)) and Si n- or p-doped amorphous silicon layer (a-Si (n)) or a combination of at least two of these layers.
|23| The solar cell according to anyone of the preceding embodiments, wherein the surface on the front side of the substrate has a texture with maxima and minima.
|24| The solar cell according to anyone of the proceeding embodiments, wherein the solar cell comprises a second metal containing layer being in an electrically conductive contact with the front side of the substrate.
|25| The solar cells according to embodiment |24|, wherein the substrate at the front side and beneath the at least one passivation layer comprises an n-doped front surface field (n⁺-FSF).
|26| The solar cells according to embodiment |25|, wherein the passivation layer is a layer of n-doped amorphous silicon (a-Si (n)) or a layer stack comprising an intrinsic undoped amorphous silicon layer (a-Si (i)) and Si n-doped amorphous silicon layer (a-Si (n)) and wherein the passivation layer is covered with a layer of a transparent conductive coating.
|27| The solar cell according to anyone of embodiments |24 |to |26|, wherein the second metal containing layer being in an electrically conductive contact with the front side of the substrate is applied in the form of a metal grid or in the form of a pattern comprising at least one metal busbar and metal fingers.
|28| The solar cell according to anyone of the proceeding embodiments, wherein the solar cell comprises second metal containing layer being in an electrically conductive contact with the back side of the substrate.
|29| The solar cell according to anyone of the preceding embodiments, wherein the conductive polymer layer comprises a cationic polythiophene as the cationic conductive polymer and a polymeric sulfonic acid or a polymeric carboxylic acid as the polymeric anion.
|30| The solar cell according to embodiment |29|, wherein in the conductive polymer layer the cationic polythiophene and the polymeric anion are present in the form of a polythiophene/polymeric anion-complex, preferably a PEDOT/PSS-complex.
|31| A process for the preperation of a solar cell comprising the process steps:
   I) providing a substrate of p-type silicon or n-type silicon, wherein the substrate comprises a front side and a back side;
   II) optionally treatment of the back side with an etching agent;
   III) covering at least a part of the optionally treated surface on the back side of the substrate with a layer of a conductive polymer;
   IV) covering at least a part of the surface of the conductive polymer layer with an electrode;
      wherein for the formation of the electrode in process step IV)
   IVa) a conductive metal layer is applied to at least a part of the surface of the conductive polymer layer by means of a conductive adhesive layer, wherein preferably the conductive adhesive layer has a conductivity of not more than 1000 S/cm, more preferably not more than 100 S/cm and even more preferably not more than 10 S/cm;
      or
   IVb) a liquid composition comprising conductive metal particles is applied onto at least a part of the surface of the conductive polymer layer, wherein preferably the liquid composition is subsequently hardened, more preferably hardened by drying or curing, to form the conductive layer.
|32| A process for the preperation of a solar cell comprising the process steps:
   I) providing a substrate of p-type silicon or n-type silicon, wherein the substrate comprises a front side and a back side;
   II) optionally treatment of the back side with an etching agent;
   III) covering at least a part of the optionally treated surface on the back side of the substrate with a layer of a conductive polymer;
   IV) covering at least a part of the surface of the conductive polymer layer with an electrode;
   V) covering at least a part of the lateral surfaces of the solar cell with a protective film, wherein step V) comprises the steps:
      Va) optionally applying an adhesive tape onto a least a part of the lateral surfaces of the solar cell, where the tape material is preferably based on a polyolefin;
      Vb) applying a curable composition onto a least a part of the lateral surfaces of the solar cell, or applying a curable composition onto at least a part of the surface of the adhesive tape;
      Vc) curing the curable composition to form the protective film.
|33| The process according to embodiment |31|, wherein the conductive metal layer is a metal foil that comprises one or more metals selected from the group consisting of copper, aluminum, tin, iron, nickel, silver, gold, lead, zinc, cobalt, chromium, titanium, and a mixtures of at least two of these metals.
|34| The process according to embodiment |33|, wherein the metal foil is a surface passivated metal foil.
|35| The process according to anyone of embodiments |31| and |33| to |34|, wherein the conductive adhesive layer is prepared by means of an adhesive composition that is applied onto at least a part of the surface of the conductive metal layer, onto at least a part of the surface of the conductive polymer layer or onto at least a part of both of these surfaces, wherein the adhesive layer obtained after drying and/or curing of the adhesive composition has a conductivity of at least 0.5 S/cm, preferably of at least 1 S.
|36| The process according to embodiment |35|, wherein the adhesive composition comprises less than 35000 ppm, preferably less than 20000 ppm and more preferably less than 1000 ppm of nitrogen, based on the total weight of the adhesive composition.
|37| The process according to embodiment |36|, wherein the adhesive composition comprises organic conductive particles, inorganic conductive particle or a mixture thereof.
|38| The process according to embodiment |37|, wherein inorganic conductive particles are carbon-based particles or metal nano particles.
|39| The process according to embodiment |38|, wherein the carbon-based particles are graphite particles.
|40| The process according to embodiment |37|, wherein the organic particles are particles comprising a polythiophene/polymeric anion-complex, preferably a PEDOT/PSS-complex.
|41| The process according to anyone of embodiments |30| to |39|, wherein the adhesive composition is an acrylate-based anaerobic adhesive composition.
|42| The process according to anyone of embodiments |31| and |33| to| 41|, wherein the conductive adhesive layer has a thickness of less than 40 µm.
|43| The process according to anyone of embodiments |31| and |33| to 42|, wherein the process comprises a further process step:
   VI) covering at least a part of the surface of the conductive polymer layer with a further conductive polymer layer that comprises metal nanowires before step IV).
|44| The process according to embodiment |43,| wherein the metal nanowires are silver nanowires.
|45| The process according to embodiment |43| or |44|, wherein the further conductive layer is a PEDOT/PSS-layer that comprises silver nanowires.
|46| The process according to embodiment |45|, wherein the further conductive layer is prepared by applying a PEDOT/PSS-dispersion comprising silver nanowires to at least a part of the surface of the conductive polymer layer, followed by a removal of at least a part of the solvent of the PEDOT/PSS-dispersion.
|47| The process according to anyone of embodiments |43| to |46|, wherein the content of metal nanowires in the further conductive layer is in the range from 15 to 70 wt.-%, based on the total weight of the further conductive layer.
|48| The process according to anyone of embodiments |43| to |47|, wherein the thickness of the further conductive layer is in the range from 60 to 500 nm.
|49| The process according to anyone of embodiments |31| and |33| to| 48|,, wherein the process comprises a further process step:
   V) covering at least a part of the lateral surfaces of the solar cell with a protective film.
|50| The process according to embodiment |32| or |49|, wherein the protective film is a layer of an epoxy resin that completely covers at least a part of the lateral surfaces of the solar cell.
|51| The process according to embodiment |49| or |50|, wherein step V) comprises the steps:
   Va) optionally applying an adhesive tape onto a least a part of the lateral surfaces of the solar cell, where the tape material is preferably based on a polyolefin;
   Vb) applying a curable composition onto a least a part of the lateral surfaces of the solar cell, or optionally onto at least a part of the surface of the adhesive tape;
   Vc) curing the curable composition to form the protective film.
|52| The process according to embodiment |51|, wherein the curable composition is a UV-curable composition that is cured by UV-light.
|53| The process according to anyone of embodiments |31| to |52|, wherein
   A) in process step III) the treated surface on the back side of the substrate is brought into contact with the layer of a conductive polymer in such a way that the conductive polymer layer is at least partially in direct contact with the surface of the p-type or n-type silicon;
   B) the conductive polymer layer comprises a cationic conductive polymer and a polymeric anion in a weight ratio cationic conductive polymer : polymeric anion of greater than 0.4, preferably greater than 0.5, more preferably greater than 0.6 and more preferably greater than 0.65.
|54| The process according to anyone of embodiments |31| to |53|, wherein the etching agent is an aqueous solution of at least one mineral acid, preferably an aqueous solution of HF, or an aqueous solution of a mixture of HF and at least one further mineral acid selected from the group consisting of HNO₃, H₂SO₄, H₃PO₄, HBr, HI, HClO₄ and HIO₄, or an aqueous solution of HF and an ammonium salt such as NH₄F, particularly preferably an aqueous hydrofluoric acid solution having a concentration the range from 0.1 to 5 wt.-%.
|55| The process according to anyone of embodiments |31| to |54|, wherein the conductive polymer layer is formed by applying a liquid composition comprising the cationic conductive polymer, the polymeric anion and a solvent onto the back side and by subsequently removing at least a part of the solvent.
|56| The process according to embodiment |55|, wherein the liquid composition comprises a cationic polythiophene as the cationic conductive polymer and a polymeric sulfonic acid or a polymeric carboxylic acid as the polymeric anion.
|57| The process according to embodiment |56|, wherein in the liquid composition the cationic polythiophene and the polymeric anion are present in the form of a polythiophene : polymeric anion-complex, preferably a PEDOT/PSS-complex.
|58| The process according to anyone of embodiments 1311 to |57|, wherein the substrate is based on n-type monocrystalline silicon (c-Si).
|59| The process according to anyone of embodiments |31| to |58|, wherein the surface on the front side of the substrate is at least partially covered with at least one passivation layer selected from the group consisting of a silicon nitride layer (SiNₓ), a silicon oxide layer (SiOₓ), a silicon carbide layer (SiC), a titanium oxide layer (TiOₓ), an aluminium oxide layer (AlOₓ), a layer of amorphous silicon (a-Si) or a layer stack comprising of an intrinsic undoped amorphous silicon layer (a-Si (i)) and Si n- or p-doped amorphous silicon layer (a-Si (n)) or a combination of at least two of these layers.
|60| The process according to anyone of embodiments |31| to |59|, wherein the surface on the front side of the substrate has a texture with maxima and minima.
|61| Solar cell, obtainable by the process according to anyone of embodiments 1311 to |60|.
|62| A solar module, comprising at least one solar cell according to anyone of embodiments |1| to |30| and |61| and at least one further solar cell.

### DETAILED DESCRIPTION OF THE INVENTION

A contribution to achieving at least one of the above described objects is made by a solar cell (subsequently referred to as the "first solar cell according to the present invention") at least comprising
i) a substrate of p-type silicon or n-type silicon, wherein the substrate comprises a front side the surface of which is at least partially covered with at least one passivation layer and a back side;
ii) a conductive polymer layer that at least partially covers the back side of the substrate;
iii) an electrode that at least partially covers the conductive polymer layer on the side of the conductive polymer layer that is facing away from the substrate;
   wherein the electrode
   iiia) is a conductive metal layer that is attached to at least a part of the surface of the conductive polymer layer by means of a conductive adhesive layer, wherein it is preferred that the conductive adhesive layer has a conductivity of not more than 1000 S/cm, more preferably not more than 100 S/cm and even more preferably not more than 10 S/cm;
      or
   iiib) is a conductive layer that has been prepared by applying a liquid composition comprising conductive metal particles onto at least a part of the surface of the conductive polymer layer, wherein it is preferred that the liquid composition is subsequently hardened, more preferably hardened by drying or curing, to form the conductive layer.

A contribution to achieving at least one of the above described objects is also made by a solar cell (subsequently referred to as the "second solar cell according to the present invention") at least comprising
i) a substrate of p-type silicon or n-type silicon, wherein the substrate comprises a front side the surface of which is at least partially covered with at least one passivation layer and a back side;
ii) a conductive polymer layer that at least partially covers the back side of the substrate;
iii) an electrode that at least partially covers the conductive polymer layer on the side of the conductive polymer layer that is facing away from the substrate;
wherein at least a part of the lateral surfaces of the solar cell is covered by protective film.

The first solar cell according to the present invention is characterized by the fact that a conductive polymer layer, such as e. g. a polythiophene layer, a polypyrrole layer or a polyaniline layer, is deposited on the solar cell back side (i. e. the side of the solar cell that is not exposed to the sun) as a hole-transporting layer and in that the back side electrode is applied onto the conductive polymer layer by simply attaching a conductive metal layer, such as a metal foil, to the conductive polymer layer with the help of an adhesive layer or, in the alternative, by applying a liquid composition onto the conductive polymer layer and by subsequently hardening the liquid composition. By means of these methods for providing the back side electrode onto the conductive polymer layer complex processes, such as evaporation or sputtering, can be avoided. The process according to the present invention therefore allows the preparation of solar cells with a high efficiency in a very cost-effective manner. The second solar cell according to the present invention is characterized by the fact the lateral surfaces of the solar cell are covered by a protective film, preferably by a protective film that is based on an epoxy resin, more preferably by a protective layer stack that comprises an adhesive tape that is applied onto the lateral surfaces of the solar cell and a protective layer that is applied onto at least a part of the surface of the adhesive tape. By means of such a protective film or protective layer stack the permeation of humidity into the layers of the solar cell, in particular into the hygroscopic conductive polymer layer can be avoided.

The first and the second solar cell according to the present invention comprises i) a substrate of p-type silicon or n-type silicon.

Doped Si substrates are well known to the person skilled in the art. The doped Si substrate can be prepared in any way known to the person skilled in the art and which he considers to be suitable in the context of the invention. Preferred sources of Si substrates according to the invention are based on amorphous silicon (a-Si), monocrystalline silicon (c-Si), multicrystalline silicon (mc-Si), upgraded metallurgical silicon (umg-Si), thin-film crystalline silicon (thinner than 50 µm) or a combination of at least two of these materials, wherein monocrystalline silicon (c-Si) is the preferred substrate material. Particularly preferred materials are n-doped or p-doped monocrystalline silicon, wherein n-doped monocrystalline silicon is the most preferred material for the substrate. Doping to form the doped Si substrate can be carried out simultaneously by adding a dopant during the preparation of the Si substrate or can be carried out in a subsequent step. Doping subsequent to the preparation of the Si substrate can be carried out for example by gas diffusion epitaxy. Doped Si substrates are also readily commercially available. According to the invention it is one option for the initial doping of the Si substrate to be carried out simultaneously to its formation by adding dopant to the Si mix.

It is known to the person skilled in the art that Si substrates can exhibit a number of shapes, surface textures and sizes. The shape can be one of a number of different shapes including cuboid, disc, wafer and irregular polyhedron amongst others. The preferred shape according to the present invention is wafer shaped where that wafer is a cuboid with two dimensions which are similar, preferably equal and a third dimension which is significantly less than the other two dimensions. Significantly less in this context is preferably at least a factor of about 100 smaller.

A variety of surface types are known to the person skilled in the art. According to the invention Si substrates with rough surfaces are preferred. One way to assess the roughness of the substrate is to evaluate the surface roughness parameter for a sub-surface of the substrate which is small in comparison to the total surface area of the substrate, preferably less than one hundredth of the total surface area, and which is essentially planar. The value of the surface roughness parameter is given by the ratio of the area of the subsurface to the area of a theoretical surface formed by projecting that subsurface onto the flat plane best fitted to the subsurface by minimising mean square displacement. A higher value of the surface roughness parameter indicates a rougher, more irregular surface and a lower value of the surface roughness parameter indicates a smoother, more even surface. According to the invention, the surface roughness of the Si substrate is preferably modified so as to produce an optimum balance between a number of factors including but not limited to light absorption and adhesion of fingers to the surface.

In this context it is preferred that the surface on the front side of the substrate (i. e. the side that is exposed to sun light) has a texture with maxima and minima. A particularly preferred texture has concave and convex patterns with a minute pyramid (i. e. square pyramid) shape. In a solar cell with such a texture at the front surface the light reflected from one spot impinges again to another spot on the surface of the crystalline solar cell by virtue of the textured surface, penetrating into the solar cell to be effectively absorbed in the solar cell. Although a portion of the impinging light that has not been fully absorbed, but arrives at the back face of the solar cell, is reflected back to the surface again, that portion of impinging light can be reflected again at the surface comprising steeply inclined pyramidal surfaces, thereby confining the light in the solar cell to improve absorption of light and to enhance power generation.

A textured structure including non-inverted pyramids can, for example, be formed by immersing the exposed face of a silicon wafer into a mixed solution prepared by adding 5 to 30% by volume of isopropyl alcohol into an aqueous solution of an alkaline, for example sodium hydroxide (NaOH) or potassium hydroxide (KOH), which may also include some added silicon. Etching in this mixed solution is performed at a temperature of from 70°C to 95°C. Further details for preparing textured structure on the surface of a Si wafer are, for example, disclosed in US 2004/0259335 A1, US 2013/0025663 A1 or WO 2012/025511 A1.

The surface of the front side of the substrate, preferably the surface of the front side of the n-type monocrystalline silicon waver, is at least partially covered with at least one passivation layer. Thorough passivation of the surface of a solar cell greatly improves the efficiency of the solar cell by reducing surface recombination. As used herein, "passivation" is defined as the chemical termination of dangling bonds present on the surface of a silicon lattice. Any passivation layer which is known to the person skilled in the art and which he considers to be suitable in the context of the invention can be employed. Preferred passivation layers according to the invention are silicon nitride layers, silicon oxide layers (SiOₓ), in particular a SiO₂ layer, silicon carbide layers (SiC), titanium oxide layers (TiOₓ), in particular a TiO₂ layer, aluminium oxide layers (AlOₓ), in particular a Al₂O₃ layer, a layer of amorphous silicon (a-Si), in particular a layer of n-doped amorphous silicon (a-Si (n)) or a layer stack comprising of an intrinsic undoped amorphous silicon layer (a-Si (i)) and Si n- or p-doped amorphous silicon layer (a-Si (n)), in particular a double layer stack consisting of an a-Si0 (i)-layer and an a-Si (n)-layer, or a combination of at least two of these layers, wherein a SiNₓ layer is most preferred. If a layer of amorphous silicon (a-Si) or a layer stack comprising of an intrinsic undoped amorphous silicon layer (a-Si (i)) and Si n-doped amorphous silicon layer (a-Si (n)) is used as the passivation layer, it is furthermore preferred that the passivation layer is covered with a layer of a transparent conductive coating, preferably a transparent conductive oxide (TCO) such as indium tin oxide (ITO). According to the invention, it is preferred for the passivation layer to have a thickness in a range from about 0.1 nm to about 1 µm, more preferably in a range from about 5 nm to about 500 nm and most preferably in a range from about 10 nm to about 250 nm.

Furthermore, the first and the second solar cell according to the present invention may further comprise an anti-reflection coating that is applied onto the passivation layer. Preferred anti-reflection coatings according to the invention are those which decrease the proportion of incident light reflected by the front face and increase the proportion of incident light crossing the front face to be absorbed by the wafer. All anti-reflection coatings known to the person skilled in the art and which he considers to be suitable in the context of the invention can be employed. Preferred anti-reflection coatings according to the present invention are those layers which have already been mentioned above as preferred passivation layers.

The thickness of anti-reflection coatings is suited to the wavelength of the appropriate light. According to the invention it is preferred for anti-reflection coatings to have a thickness in a range from about 20 to about 300 nm, more preferably in a range from about 40 to about 200 nm and most preferably in a range from about 60 to about 150 nm.

A single layer can serve as both, i.e. as an anti-reflection layer and as a passivation layer. In one embodiment of the solar cell according to the present invention, one or more layers which act as anti-reflection layer and/or passivation layer are present at the front side of the substrate. For example, the passivation layer can be a dielectric double layer comprising an aluminium oxide containing layer, preferably an Al₂O₃ layer, or a silicon oxide containing layer, preferably a SiO₂ layer, and a further layer covering the aluminium oxide or the silicon oxide containing layer, wherein the further layer is selected from the group consisting of a silicon nitride layer, in particular a Si₃N₄-layer, a silicon oxide layer, a silicon carbide layer or a combination of at least two of these layers, preferably a silicon nitride layer.

The application of the above mentioned layers can be performed by means of PECVD (plasma enhanced chemical vapor deposition), APCVD (atmospheric pressure chemical vapor deposition) or atomic layer deposition (ALD). The deposition of an n-doped a-Si passivation layer can be effected by means of PECVD using silane, hydrogen and phosphine, as it is, for example, disclosed in US 2007/0209699 A1.

The first and the second solar cell according to the present invention further comprises ii) a conductive polymer layer that at least partially covers the back side of the substrate.

As a conductive polymer conjugated polymers such as polypyrroles, polythiophenes, polyanilines, polyacetylenes or polyphenylenes can be used, wherein the use of polythiophenes is particularly preferred. According to a preferred embodiment of the solar cell according to the present invention the conductive polymer therefore comprises a polythiophene. Preferred polythiophenes are those having repeating units of the general formula (I) or (II) or a combination of units of the general formulas (I) and (II), preferably a polythiophene with repeating units of the general formula (II): 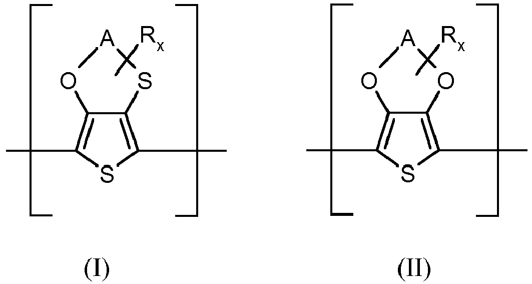 wherein
- A: stands for an optionally substituted C₁-C₅-alkylene radical,
- R: stands for a linear or branched, optionally substituted C₁-C₁₈-alkyl radical, an optionally substituted C₅-C₁₂-cycloalkyl radical, an optionally substituted C₆-C₁₄-aryl radical, an optionally substituted C₇-C₁₈-aralkyl radical, an optionally substituted C₁-C₄-hydroxyalkyl radical or a hydroxyl radical,
- x: stands for a whole number from 0 to 8 and

in the case where multiple radicals R are connected to A, these can be identical or different.

The general formulas (I) and (II) are to be so understood, that x substituents R can be connected to alkylene radical A.

Particularly preferred as polythiophene is poly(3,4-ethylenedioxythiophene).

The conductive polymer layer may further comprise a polymeric anion, preferably a polymeric anion based on polymers functionalised with acid groups, such as a polymeric sulfonic acids such as polystyrenesulphonic acids and polyvinylsulphonic acids, or a polymeric carboxylic acid. These polycarboxylic and -sulphonic acids can also be copolymers of vinylcarboxylic and vinylsulphonic acids with other polymerizable monomers, such as acrylic acid esters and styrene. Particularly preferably, the solid electrolyte comprises an anion of a polymeric carboxylic or sulphonic acid for compensation of the positive charge of the polythiophene.

The molecular weight of the polyacids which supply the polyanions is preferably 1000 to 2000000, particularly preferably 2000 to 500000. The polyacids or their alkali metal salts are commercially obtainable, e.g. polystyrenesulphonic acids and polyacrylic acids, or can be prepared by known processes (see e.g. Houben Weyl, Methoden der organischen Chemie, vol. E 20 Makromolekulare Stoffe, part 2, (1987), p. 1141 et seq.).

Particularly suitable as polymeric anion is polystyrene sulphonic acids (PSS).

According to a particularly preferred embodiment of the solar cell according to the present invention the conductive polymer layer comprises a cationic conductive polymer, preferably a cationic polythiophene, as the conductive polymer and a polymeric anion as a counter-ion for the cationic conductive polymer, preferably a polymeric sulfonic acid or a polymeric carboxylic acid, wherein it is particularly preferred that the cationic polythiophene and the polymeric anion are present in the form of a polythiophene/polymeric anion-complex, preferably a poly(3,4-ethylenedioxythiophene) : polystyrene sulfonic acid complex (also referred to as "PEDOT/PSS-complex"). Such a complex can be obtained if the monomers on which the polythiophene is based (such as 3,4-ethylenedioxythiophene) are polymerized in the presence of the polymeric anion in an aqueous solution as disclosed by Kirchmeyer et al. in the Journal of Materials Chemistry (2005), 15(21), pages 2077-2088. In this context it may be particularly preferred that the conductive polymer layer comprises the cationic conductive polymer, preferably poly(3,4-ethylenedioxythiophene), and the polymeric anion, preferably a polymeric sulfonic acid such as PSS, in a weight ratio cationic conductive polymer : polymeric anion of greater than 0.4, preferably greater than 0.5, more preferably greater than 0.6 and even more preferably greater than 0.65. If, for example, the conductive polymer layer comprises 1 part by weight of the cationic conductive polymer and 2 parts by weight of the polymeric sulfonic acid, the weight ratio cationic conductive polymer : polymeric acid would be 0.5 (i. e. 1 : 2).

The layer thickness of the conductive polymer layer preferably lies in a range from 1 nm to 10 µm, particularly preferably in a range from 10 nm to 500 nm and most preferably in a range from 20 nm to 400 nm. The surface resistance of the conductive polymer layer preferably lies in a range from 1 to 5000 Ω/sq, preferably in a range from 10 to 1000 Ω/sq and most preferably in a range from 10 to 250 Ω/sq.

According to a preferred embodiment of the first and the second solar cell according to the present invention at least one of the following conditions a) and b) is fulfilled:
a) the conductive polymer layer is at least partially in direct contact with the surface of the p-type or n-type silicon;
b) the conductive polymer layer comprises a cationic conductive polymer and a polymeric anion in a weight ratio cationic conductive polymer : polymeric anion of greater than 0.4, preferably greater than 0.5, more preferably greater than 0.6 and even more preferably greater than 0.65.

According to a first particular variant of this preferred embodiment of the first and the second solar cell according to the present invention condition a) is fulfilled. According to a second particular variant of this preferred embodiment of the first and the second solar cell according to the present invention condition b) is fulfilled. According to a third particular variant of this preferred embodiment of the first and the second solar cell according to the present invention conditions a) and b) are fulfilled.

According to condition a) the conductive polymer layer is at least partially in direct contact with the surface of the p-type or n-type silicon. The expression "*the conductive polymer layer is ...in direct contact with the surface of the p-type or n-type silicon*" preferably is understood in such a way that the components of the conductive polymer layer (i. e. the conductive polymer, in particular the complex of the conductive polymer and the polymeric anion) are in direct contact with the p-type or n-type silicon. In these areas of direct contact there is no further layer, in particular no passivation layer based on SiOₓ arranged between the p-type or n-type silicon and the components of the conductive polymer layer. Such a direct contact can be achieved by applying a liquid composition comprising a conductive polymer and a solvent to the back side of the substrate under a condition in which at least in a part of the surface on the back side of the substrate the p-type or n-type silicon is freely accessible. This can, for example, be accomplished by treating this surface with an etching solution before applying the conductive polymer layer, as described in detail later.

According to one embodiment of the solar cell according to the present invention at least 5 %, preferably at least 25 %, more preferably at least 50 %, even more preferably at least 75 % and most preferably at least 95 % of the surface of the p-type or n-type silicon on the back side of the substrate are in direct contact with the conductive polymer layer. According to a particularly preferred embodiment the complete surface of the p-type or n-type silicon on the back side of the substrate is in direct contact with the conductive polymer layer.

According to another embodiment of the solar cell according to the present invention in up to 95 %, preferably in up to 75 %, more preferably in up to 50 %, even more preferably in up to 25 % and most preferably in up to 5 % of the surface on the back side of the substrate the p-type or n-type silicon is not in direct contact with the conductive polymer layer. In these areas it is particularly preferred that a thin passivation layer, preferably a passivation layer based on SiOₓ, is arranged between the p-type or n-type silicon and the conductive polymer layer. The thickness of the passivation layer, preferably of the SiOₓ-layer, is preferably in the range from 0.2 nm to 1.0 nm. In the case of a SiO₂-layer the thickness of the passivation layer in these areas is preferably within about one or two monolayers of silicon dioxide. The thickness of such ultrathin passivation layers can, for example, be determined by high-resolution electron microscopy (HREM).

A surface of a substrate, preferably a surface of a substrate of p-type silicon or n-type silicon in which at least a part of the surface of the p-type or n-type silicon on the back side of the substrate is freely accessible and in which optionally a further part of the surface of the p-type or n-type silicon on the back side of the substrate is covered by SiOₓ as described above can, for example, be obtained by treating the back side of the substrate with an etching agent in order to remove any passivation layers that may be present on the back side of the substrate and that either
- may have been applied intentionally on the back side of the substrate (for example to protect the back side in previous fabrications steps or as a result of the formation of a passivation layer on the front side) or
- may have been formed while storing the substrate at ambient air (which may lead to the formation of a SiOₓ-based passivation layer).

A process of reducing the thickness of passivation layers or to completely remove such passivation layers is, for example, disclosed in EP 844 650 A2.

According to a particular embodiment of the first and the second solar cell according to the present invention the passivation layer on the back side is, at least in certain areas, completely removed by this treatment such that in these areas the p-type or n-type silicon is freely accessible. Suitable etching agents are aqueous solutions of at least one mineral acid, preferably an aqueous solution of HF or an aqueous solution of a mixture of HF and at least one further mineral acid selected from the group consisting of HNO₃, H₂SO₄, H₃PO₄, HBr, HI, HClO₄ and HIO₄ or an aqueous solution of HF and an ammonium salt such as NH₄F. Particularly suitable is an aqueous hydrofluoric acid solution having a concentration in the range from 0.1 to 5 wt.-%. Methods for etching SiOₓ-layers on the surface of p-type or n-type silicon are disclosed, for example, in EP 844 650 A2.

The first and the second solar cell according to the present invention further comprises an electrode (subsequently also referred to as - the first electrode -) that at least partially covers the conductive polymer layer one the side of the conductive polymer layer that is facing away from the substrate, wherein in the first solar cell according to the present invention this electrode
iiia) is a conductive metal layer (subsequently also referred to as - the first conductive metal layer -) that is attached to at least a part of the surface of the conductive polymer layer by means of a conductive adhesive layer, wherein it is preferred that the conductive adhesive layer has a conductivity of not more than 1000 S/cm, more preferably not more than 100 S/cm and even more preferably not more than 10 S/cm;
   or
iiib) is a conductive layer that has been prepared by applying a liquid composition comprising conductive metal particles onto at least a part of the surface of the conductive polymer layer, wherein it is preferred that the liquid composition is subsequently hardened, preferably hardened by drying or curing, to form the conductive layer.

According to alternative iiia) the first electrode is a conductive metal layer that has been applied to at least a part of the surface of the conductive polymer layer by means of a conductive adhesive layer wherein the conductive adhesive layer preferably has a conductivity of not more than 1000 S/cm, more preferably not more than 100 S/cm and even more preferably not more than 10 S/cm. According to a particular preferred embodiment the conductive adhesive layer has conductivity in the range from 1 to 5 S/cm, more preferably 1 to 2 S/cm.

The conductive metal layer is preferably a metal foil comprises one or more metals selected from the group consisting of copper, aluminum, tin, iron, nickel, silver, gold, lead, zinc, cobalt, chromium, titanium, and a mixtures of at least two of these metals, wherein a copper foil, a silver foil, a gold foil or an aluminium foil is particularly preferred and a copper foil or a silver foil is most preferred. The metal foil can also be a surface passivated metal foil, preferably a surface passivated metal foil that comprises any of the metals mentioned before, particularly preferred a surface passivated copper foil or a surface passivated aluminium foil, most preferably a titanium or carbon passivated aluminium foil.

The thickness of the metal foil is preferably in the range from 1 µm to 250 µm, more preferably in the range from 1 µm to 150 µm and most preferably in the range from 5 µm to 50 µm.

In the first solar cell according to the present invention different adhesives can be used to attach the conductive metal layer to the conductive polymer layer, wherein those adhesives are particularly preferred that, when being cured or dried, form a conductive adhesive layer having a surface resistance in the ranges given above. Most preferred adhesive for the preparation of the adhesive layer are those adhesives that, in a cured or dried state, form a conductive adhesive layer that comprises less than 35000 ppm, preferably less than 20000 ppm and most preferably less than 1000 ppm nitrogen, in each case based on the total weight of the adhesive layer. Thus, the adhesive layer in the solar cell according to the present invention preferably comprises nitrogen in these maximum amounts.

Preferably, the electrically conductive adhesive layer comprises organic conductive particles, inorganic conductive particle or a mixture thereof.

Preferred inorganic conductive particles are carbon-based particles or metal nano particles, whereon graphite particles are particularly preferred carbon based particles. Preferred metal nano particles may include at least one selected from the group of silver (Ag), gold (Au), palladium (Pd), platinum (Pt), copper (Cu), chromium (Cr), cobalt (Co), aluminum (Al), tin (Sn), lead (Pb), zinc (Zn), iron (Fe), iridium (Ir), osmium (Os), rhodium (Rh), tungsten (W), molybdenum (Mo), nickel (Ni), and indium tin oxide (ITO) particles. These particles may be used alone or as a mixture of two or more thereof. It is also possible that one of the afore mentioned metals or even nonconductive materials form the core of the particle, while a second metal is building at least a partial shell around the core material. The inorganic conductive particles may have a spherical shape, a flake shape, an amorphous shape, a rod-like shape or a combination thereof. The average particle diameter of the inorganic conductive particles is preferably in the range from 0.01 to 60 µm, more preferably in the range from 0.1 to 40 µm. Also suitable are, for example, metal nanowires, in particular silver nanowires (AgNW). The metal nanowires are preferably characterized by a length of from 1 µm to 200 µm and by a diameter of from 50 nm to 1300 nm. Preferably, the metal nanowires have an aspect ratio (length : diameter) of at least 10 : 1, more preferably of at least 100 : 1 and most preferably they have an aspect ratio in a range of from 100 : 1 to 1000 : 1.

Preferred organic particles are conductive polymer particles, wherein preferred conducive polymers are polythiophenes, polypyrroles, polyanilines or derivatives of these conductive polymers. Particularly preferred conductive polymer particles are the above described polythiophene/polyanion-complexes, particularly preferred the above described PEDOT/PSS-particles. The weight average particle diameter of these conductive polymer particles is preferably less than 400 nm, preferably less than 2000 nm, more preferably less than 150 nm, even more preferably less than 1200 nm, even more preferably less than 100 nm and most preferably less than 80 nm. The conductive polymer particles may furthermore be characterized by a d₁₀ value of greater than 1 nm and a d₉₀ value of less than 400 nm, particularly preferably a d₁₀ value of greater than 5 nm and a d₉₀ value of less than 200 nm, very particularly preferably a d₁₀ value of greater than 10 nm and a d₉₀ value of less than 100 nm. In this context, the d₁₀ value of the diameter distribution states that 10% of the total weight of all the particles comprising the conductive polymer i) in the composition according to the present invention can be assigned to those particles which have a diameter of less than or equal to the d₁₀ value. The d₉₀ value of the diameter distribution states that 90% of the total weight of all the particles comprising the conductive polymer i) in the composition according to the present invention can be assigned to those particles which have a diameter of less than or equal to the d₉₀ value.

The total content of organic and/or inorganic conductive particles in the conductive adhesive layer is preferably in the range from 1 to 100 wt.-%, more preferably in the range from 10 to 100 wt.-% and most preferably in the range from 15 to 80 wt.-%, in each case based on the total weight of the conductive adhesive layer.

In the conductive adhesive layer these inorganic and/or organic conductive particles are preferably imbedded in a matrix, wherein the composition of the matrix depends on the composition of the adhesive that has been used for the formation of the adhesive layer. The adhesive that is used for the formation of the conductive adhesive layer can be any adhesive that the person skilled in the art considered suitable for attaching the conductive metal layer, preferably the above described metal foil, to the conductive polymer layer, preferably to the PEDOT/PSS-layer. These adhesives can be
- non-reactive adhesives such as
   -- drying adhesives, for example solvent-based adhesives or polymer dispersion adhesives,
   -- pressure-sensitive adhesives, for example those based on methacrylics, acrylics, butyl rubber, ethylene-vinyl acetate (EVA) with high vinyl acetate content, natural rubber, nitriles, silicone rubbers, styrene block copolymers (SBC), vinyl ethers or saccharides,
   -- contact adhesives, for example those based on natural or synthetic rubbers, or
   -- hot melt adhesives, for example preferably those based on thermoplastic polymers,
      or
- reactive adhesives such as
   -- multi-part adhesives that harden by mixing two or more components which chemically react with each other, for example polyester resin/polyurethane-adhesives, polyol/polyurethane-adhesives or acrylic polymer/polyurethane-adhesives, or
   -- one-part adhesives that harden via a chemical reaction with an external energy source, such as radiation, heat, and moisture, for example adhesives that are cured by heat and that are based on, for example, epoxies, urethanes or polyimides.

According to a first particular embodiment of the first solar cell according to the present invention the conductive adhesive layer has been prepared by means of an adhesive that is water-based and that comprises graphite particles. Particular examples for such an adhesive are the water-based graphite conductive adhesives No. 41214 or 42466 obtainable from Thermo Fisher Scientific, Karlsruhe, Germany.

According to a second particular embodiment of the solar cell according to the present invention the adhesive layer has been prepared by means of a reactive adhesive that comprises metal particles. Particular examples for such an adhesive are DELOMONOPOX^{®} IC342, DELOMONOPOX^{®} DA 375 or DELOMONOPOX^{®} DA772 obtainable from DELO Industrie Klebstoffe, Windach, Germany or Polytec PT EC101 and Polytec PT EC275 obtainable from Polytec PT GmbH, Waldbronn, Germany.

According to a third particular embodiment of the first solar cell according to the present invention the conductive adhesive layer has been prepared by means of a adhesive that comprises carbon based particles. A particular example for such an adhesive is Wire Glue obtainable from Anders Products, Andover, MA 01810, USA.

According to a fourth particular embodiment of the first solar cell according to the present invention the adhesive layer has been prepared by means of a non-reactive adhesive that comprises PEDOT/PSS-particles, preferably a non-reactive, pressure sensitive adhesive that is based on a PEDOT/PSS-dispersion comprising a saccharide, such as D-sorbitol.

According to alternative b) the first electrode is a conductive layer that has been prepared by applying a liquid composition comprising conductive metal particles onto at least a part of the surface of the conductive polymer layer, wherein the liquid composition is subsequently hardened, preferably hardened by drying or curing, to form the conductive layer. Preferred conductive metal particles are the inorganic conductive particles that have been previously mentioned in connection with the adhesive layer. In this context it is, however, particularly preferred that the conductive metal particles are not pure silver particles.

The first and the second solar cell according to the present invention may further comprise a further conductive layer that comprises metal nanowires, in particular silver nanowires, wherein this further conductive layer is preferably arranged between the conductive polymer layer that at least partially covers the back side of the substrate, and the adhesive layer. This further conductive layer preferably further comprises particles of a polythiophene/polyanion-complex, in particular PEDOT/PSS-particles. According to a particular preferred embodiment of the solar cell according to the present invention the further conductive layer is a PEDOT/PSS-layer that comprises silver nanowires, wherein the content of silver nanowires in this further conductive layer is preferably in the range from 5 to 95 wt.-%, more preferably in the range from 20 to 70 wt.-%, based on the total weight of the further conductive layer. The thickness of the further conductive layer is preferably in the range from 30 to 1000 nm, more preferably in the range from 60 to 350 nm.

The first and the second solar cell according to the present invention preferably also comprises a second electrode, wherein
- according to a first particular embodiment of the first and the second solar cell according to the present invention the solar cell is configured to have the second electrode at the front side of the solar cell,
- according to a second particular embodiment of the first and the second solar cell according to the present invention the solar cell is configured to have both electrodes (i. e. the first and the second electrode) on the back side of the solar cell. This structure is also called "*back contact, back junction (BCBJ) solar*".

### Solar cell according to the first particular embodiment

In this particular embodiment the solar cell is configured to have a second electrode at the front side and the first electrode at the back side of the solar cell. In this context it is preferred that the solar cell comprises a second metal containing layer being in an electrically conductive contact with the front side of the substrate and the first conductive metal layer (or, in case of alternative iiib), the conductive layer) being in an electrically conductive contact with the conductive polymer layer at the back side of the substrate.

The second metal containing layer being in an electrically conductive contact with the front side of the substrate is preferably applied in the form of a metal grid or in the form of a pattern comprising at least one metal busbar and metal fingers to allow light to be absorbed by the exposed silicon surface. The front grid or the front fingers can be deposited in embedded grooves to reduce shading losses. This type of solar cell is often known as a "*Buried Contact solar cell*" (also referred to as a "*Laser Grooved Buried Grid (LGBG) solar cell*". Such a solar cell is, for example, disclosed in EP 0 156 366 A2.

The metal containing layer at the front side of the substrate can, for example, be based on aluminum (Al), gold (Au), silver (Ag), nickel (Ni) coated with copper (Cu) or chromium (Cr) coated with gold(Au) or silver (Ag) or a stack comprising titanium (Ti), palladium (Pd) and silver (Ag). In industry, for forming a silver grid, a silver containing paste (which often includes silver particles, an organic binder and glass frit) is printed onto the wafers and then fired at temperature between 700°C and 900°C. The high-temperature firing of the silver paste ensures a good contact between silver and silicon, and lowers the resistivity of the silver lines. Furthermore, conventional thin film evaporation techniques, such as electron beam evaporation, can be used for forming a metal grid or a pattern comprising at least one metal busbar and metal fingers on the front surface of the solar cell. For forming the pattern shadow masks can be used or the pattern can be formed by means of conventional photolithographic techniques.

In connection with the solar cell according to the first particular embodiment it is furthermore preferred that the substrate, preferably the n-type monocrystalline silicon wafer, at the front side and beneath the passivation layer comprises an n-doped front surface field (n⁺-FSF). If the substrate comprises an n⁺-FSF, the metal containing layer at the front side of the substrate is in electrically conductive contact with at least a portion of the n⁺-FSF.

The presence of a heavily doped region at the front side of the substrate allows much better electrical contact between the solar cell and the metallic contacts at the front side and significantly lowers the series resistance of the solar cell. The use of heavily n-doped regions on the front side surface also has the advantage of a higher efficiency of the solar cells due to reduced recombination losses under the metalized area due to the strongly reduced hole concentration within the n⁺-FSF. The layer resistance of the n⁺-FSF is preferably in a range of 10 to 500 ohm/sq.

Preferred n-type dopants according to the invention are those which add electrons to the Si wafer band structure. They are well known to the person skilled in the art. All dopants known to the person skilled in the art and which he considers to be suitable in the context of the invention can be employed as n-type dopant. Preferred n-type dopants according to the invention are elements of group 15 of the periodic table. Preferred group 5 elements of the periodic table in this context include N, P, As, Sb or a combination of at least two thereof, wherein P is particularly preferred. In one embodiment of the invention, the n-doped layer comprises P as dopant.

An n⁺-FSF can be made for example by means of a gas diffusion step at a temperature of 800-950°C for several tens of minutes, as described for example in document J.C.C. Tsai, "Shallow Phosphorus Diffusion Profiles in Silicon", Proc. of the IEEE 57 (9), 1969, p. 1499-1506, or by means of an ion implantation of phosphorus atoms, followed by a step of thermal activation of the implanted atoms, as described for example in the publication of Meier et al., "N-Type, ion Implanted silicon solar cells and modules", Proc. 37 th PVSC, LA, page 3337.

### Solar cell according to the second particular embodiment

In this particular embodiment the solar cell is configured to have both electrodes (i. e. the first and the second electrode) on the back side of the solar cell ("*back contact, back junction (BCBJ)*"). In this embodiment the solar cell comprises a second metal containing layer being in an electrically conductive contact with the back side of the substrate and the first metal containing layer (or, in case of alternative iiib), the conductive layer) being in an electrically conductive contact with the conductive polymer layer on the back side of the substrate.

Such BCBJ-cell has a higher efficiency potential compared to a solar cell in which both sides are contacted as the shadowing at the front side can be omitted. With conventional high temperature diffusion, however, the processing is complex and requires a high number of process steps including masking steps for locally generating n⁺- and p⁺-regions on the back side of the cell. By local application of a conductive polymer layer such as a PEDOT/PSS-layer on the back side of the solar cell, for example by screen printing, the processing of such BCBJ-cell is greatly simplified as only the conventionally produced phosphorus-diffused n⁺-region has to be masked. The conventionally produced n⁺-region shows a higher recombination than the conductive polymer/n-Si -junction. However, since the n⁺-contact region in n-type silicon based BCBJ-solar cells is advantageously limited to a small area (typically ≤ 20%) and as the conductive polymer/n-Si -junction is characterized by a good passivation effect, it is still possible to achieve a high efficiency with a simple process sequence.

In the second particular embodiment of the solar cell according to the present invention the back side of the solar cell comprises two patterned structures:
- In the first patterned structure selected regions on the back side of the substrate are provided with n⁺-regions. The regions of this first patterned structure are in an electrically conductive contact with a second grid forming the second metal containing layer.
- In the second patterned structure in further selected regions on the back side of the substrate the p-type silicon or n-type silicon is at least partially in direct contact with the conductive polymer layer, preferably with a conductive polymer layer comprising a polythiophene. The regions of this patterned structure are in contact with a first grid forming the first metal containing layer.

In this context it is preferred that not more than 50 %, preferably not more than 30 % and most preferably not more than 20 % of the total area on the back side of the solar cell is provided with an n⁺-regions.

In addition to the layers described above which directly contribute to the principle function of the solar cell according to the present invention, in particular the solar cell according to the above described first and second particular embodiment, further layers can be added for mechanical and chemical protection.

In a particular preferred embodiment of the first solar cell according to the present invention and also in the second solar cell according to the present invention at least a part of the lateral surfaces of the solar cell is covered by protective film. In this context it is particularly preferred that the protective film is a protective polymer film, preferably a protective film in the form of a layer of an epoxy resin that completely covers the lateral surfaces of the solar cell. Such protective films can be obtained by means of a reactive adhesive, wherein those reactive adhesives can be used that have been described above. Preferred adhesives that are curable by UV-light, such as DELO-KATIOBOND^{®} LP 655 obtainable from DELO Industrie Klebstoffe, Windach, Germany.

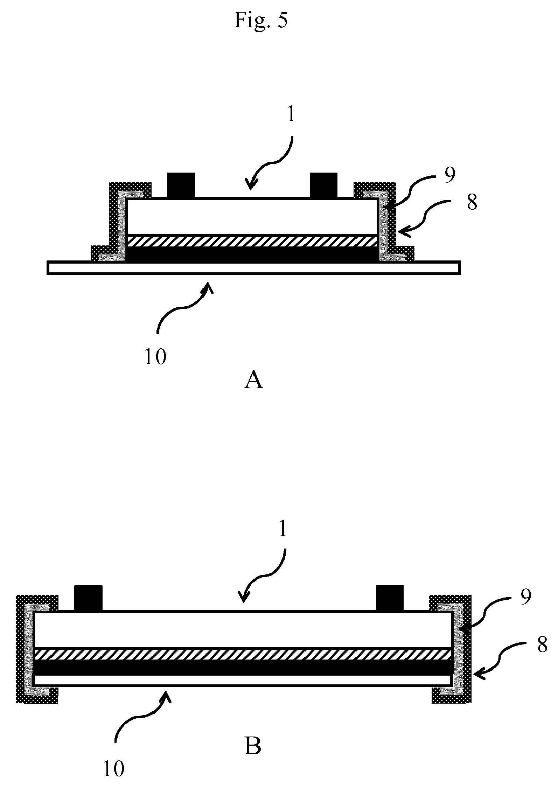

In this context it may furthermore be advantageous that a layer of an adhesive polymer tape, preferably an adhesive polyolefin tape such as an adhesive polyethylene tape, is arranged between the lateral surfaces of the solar cell on the one side the and the protective film on the other side. By means of such an adhesive tape, which itself does not have to be impermeable for humidity, the solar cell can be fixed to a carrier substrate, such as a metal foil (wherein the carrier substrate can also serve as the first electrode), by applying the adhesive tape at the edges of the solar as shown in figure 5. If a carrier substrate is used the size of which is larger than the size of the substrate of the solar cell, the solar cell can be attached to the carrier substrate by applying the adhesive tape onto the border area of the front surface, onto the lateral surface of the solar cell and onto the carrier substrate (see figure 5a). If a carrier substrate is used the size of which corresponds to the size of the substrate of the solar cell, the solar cell can be attached to the carrier substrate by applying the adhesive tape onto the border area of the front surface, onto the lateral surface of the solar cell and onto the border surface of the carrier substrate on the side of the carrier substrate that is facing away from the solar cell (see figure 5b). To ensure that humidity cannot penetrate into the layers of the solar cell, in particular into the conductive polymer layer, the thus applied adhesive tape is coated with the protective film, preferably with a protective film in the form of a layer of an epoxy resin. Suitable metal foils that can be used as the carrier substrate are those metal foils that have already been mentioned in connection with the first solar cell according to the present invention.

A transparent glass sheet can be added to the front side and/or to the back side of the first and the second solar cell according to the present invention to provide mechanical protection. Transparent glass sheets are well known to the person skilled in the art and any transparent glass sheet known to him and which he considers to be suitable in the context of the present invention can be employed as protection on the front side of the solar cell. If a glass sheet is used to protect the front side and the back side of the solar cell, the border area of these glass sheets can be sealed by appropriate sealing means such as, for example, by means of silicon-based polymer materials.

A back protecting material can be added to the back side of the solar cell to provide mechanical protection. Back protecting materials are well known to the person skilled in the art and any back protecting material which is known to the person skilled in the art and which he considers to be suitable in the context of the present invention can be employed as protection on the back face of the solar cell. Preferred back protecting materials according to the present invention are those having good mechanical properties and weather resistance. The preferred back protection material according to the present invention is polyethylene terephthalate with a layer of polyvinyl fluoride. It is preferred according to the present invention for the back protecting material to be present underneath the encapsulation layer (in the event that both a back protection layer and encapsulation are present).

A frame material can be added to the outside of the solar cell to give mechanical support. Frame materials are well known to the person skilled in the art and any frame material known to the person skilled in the art and which he considers suitable in the context of the present invention can be employed as frame material. The preferred frame material according to the present invention is aluminum.

A contribution to achieving at least one of the above described objects is also made by a process for the preparation of a solar cell (subsequently referred to the "first process according to the present invention") comprising the process steps:
I) providing a substrate of p-type silicon or n-type silicon, wherein the substrate comprises a front side and a back side;
II) optionally treatment of the back side with an etching agent;
III) covering at least a part of the optionally treated surface on the back side of the substrate with a layer of a conductive polymer;
IV) covering at least a part of the surface of the conductive polymer layer with an electrode; wherein for the formation of the electrode in process step IV)
IVa) a conductive metal layer is applied to at least a part of the surface of the conductive polymer layer by means of a conductive adhesive layer, wherein it is preferred that the conductive adhesive layer has a conductivity of not more than 1000 S/cm, more preferably not more than 100 S/cm and even more preferably not more than 10 S/cm;
   or
Vb) a liquid composition comprising conductive metal particles is applied onto at least a part of the surface of the conductive polymer layer, wherein it is preferred that the liquid composition is subsequently hardened, preferably hardened by drying or curing, to form the conductive layer.

A contribution to achieving at least one of the above described objects is also made by a process for the preparation of a solar cell (subsequently referred to the "second process according to the present invention") comprising the process steps:
I) providing a substrate of p-type silicon or n-type silicon, wherein the substrate comprises a front side and a back side;
II) optionally treatment of the back side with an etching agent;
III) covering at least a part of the optionally treated surface on the back side of the substrate with a layer of a conductive polymer;
IV) covering at least a part of the surface of the conductive polymer layer with an electrode;
V) optionally applying an adhesive tape onto a least a part of the lateral surfaces of the solar cell, where the tape material is preferably based on a polyolefin;
VI) applying a curable composition onto a least a part of the lateral surfaces of the solar cell, or optionally onto at least a part of the surface of the adhesive tape;
VII) curing the curable composition to form the protective film.

In process step I) of the first and the second process according to the present invention a substrate of p-type silicon or n-type silicon is provided, wherein the substrate comprises a front side and a back side.

Preferred substrates are those that have already been mentioned as preferred substrates in connection with the first and the second solar cell according to the present invention, wherein a n-doped monocrystalline silicon wafer is the most preferred substrate.

As already described in connection with the first and the second solar cell according to the present invention the front side of the substrate (i. e. the side that is exposed to the sun light) can have a texture with maxima and minima, wherein those textures are preferred that have already been described in connection with the solar cell according to the present invention (i. e. a concave and convex pattern with a minute pyramid (i. e. square pyramid) shape).

The front side of the substrate that is provided in process step I) may at least partially be covered with at least one passivation layer. However, it is also possible to apply such a passivation layer (or such passivation layers) onto the surface of the front side of the substrate after performing process step II) or process step III). Preferred passivation layers are again those passivation layers that have already been described in connection with the solar cell according to the present invention (i. e. silicon nitride layers, silicon oxide layers (SiOₓ), in particular a SiO₂ layer, silicon carbide layers (SiC), titanium oxide layers (TiOₓ), in particular a TiO₂ layer, aluminium oxide layers (AlOₓ), in particular a Al₂O₃ layer, a layer of amorphous silicon (a-Si), in particular a layer of n-doped amorphous silicon (a-Si (n)) or a layer stack comprising of an intrinsic undoped amorphous silicon layer (a-Si (i)) and Si n- or p-doped amorphous silicon layer (a-Si (n)), in particular a double layer stack consisting of an a-Si0 (i)-layer and an a-Si (n)-layer, or a combination of at least two of these layers), wherein layers of SiNₓ are most preferred. These layers may also simultaneously function as anti-reflection layers, as already mentioned in connection with the solar cell according to the present invention. If a layer of amorphous silicon (a-Si) or a layer stack comprising of an intrinsic undoped amorphous silicon layer (a-Si (i)) and Si n-doped amorphous silicon layer (a-Si (n)) is used as the passivation layer, it is furthermore preferred that the passivation layer is covered with a layer of a transparent conductive coating, preferably a transparent conductive oxide (TCO) such as indium tin oxide (ITO).

The application of the above mentioned layers can be performed by means of PECVD (plasma enhanced chemical vapor deposition), APCVD (atmospheric pressure chemical vapor deposition) or atomic layer deposition (ALD).

Depending on the kind of solar cell that is produced by the first and the second process according to the present invention (i. e. a solar cell that is configured to have a second electrode at the front side and a first electrode at the back side of the solar cell or a solar cell that is configured to have both electrodes on the back side of the solar cell) the substrate provided in process step I) may comprise further layers.
- If the solar cell is configured to have a second electrode at the front side and a first electrode at the back side of the solar cell, the substrate may further comprise a n-doped front surface field (n⁺-FSF) as described in connection with the first particular embodiment of the solar cell according to the present invention. This n-doped front surface field may further be in an electrically conductive contact with the second electrode, which may have been applied in the form of a grid or in the form of a pattern comprising at least one metal busbar and metal fingers.
- If the solar cell is configured to have both electrodes on the back side of the solar cell, the substrate may comprise n⁺-areas in the form of a pattern on the back side of the solar cell, as already described in connection with the second particular embodiment of the solar cell according to the present invention.

The back side of the substrate of p-type silicon or n-type silicon that is provided in process step I) may comprise a passivation layer. As explained above, such a passivation layer may have been applied intentionally on the back side of the substrate (for example to protect the back side in previous fabrications steps or as a result of the formation of a passivation layer on the front side) or may have been formed unintentionally while storing the substrate at ambient air (which leads to the formation of an SiOₓ-based passivation layer). To decrease the thickness of such a passivation layer or preferably to at least partially remove such a passivation layer to such an extend that at least in certain areas on the backside of the solar cell the p-type silicon or n-type silicon is freely accessible, the back side may be treated with an etching agent in process step II). As stated above, suitable etching agent are aqueous solutions of at least one mineral acid, preferably an aqueous solution of HF or an aqueous solution of a mixture of HF and at least one further mineral acid selected from the group consisting of HNO₃, H₂SO₄, H₃PO₄, HBr, HI, HClO₄ and HIO₄, or an aqueous solution of HF and an ammonium salt such as NH₄F. Particularly suitable is an aqueous hydrofluoric acid solution having a concentration the range from 0.1 to 5 wt.-%. Methods for etching SiOₓ-layers on the surface of p-type or n-type silicon are disclosed, for example, in EP 844 650 A2.

Preferably, the back side is treated with the etching agent to such an extent that at least 5 %, preferably at least 25 %, more preferably at least 50 %, even more preferably at least 75 % and most preferably at least 95 % of the surface of the p-type or n-type silicon on the back side of the substrate are freely exposed so that in process step III) the p-type or n-type silicon can come into direct contact with the conductive polymer layer. According to a particular preferred embodiment of the process according to the present invention the back side is treated with the etching solution to such an extent that the complete surface of the p-type or n-type silicon on the back side of the substrate is freely exposed. It is, however, also possible that the back side is treated with the etching agent only to such an extent that in up to 95 %, preferably in up to 75 %, more preferably in up to 50 %, even more preferably in up to 25 % and most preferably in up to 5 % of the surface on the back side of the substrate the p-type or n-type silicon does not come direct contact with the conductive polymer layer that is applied in process step III). In these areas a thin passivation layer, preferably a SiOₓ layer, may remain on the surface on the back side of the substrate. The thickness of the passivation layer, preferably of the SiOₓ-layer, is preferably in the range from 0.2 nm to 1.0 nm. In the case of a SiO₂-layer the thickness of the passivation layer in these areas is preferably within about one or two monolayers of silicon dioxide.

In process step III) of the first and the second process according to the present invention the optionally treated surface on the back side of the substrate is covered with a conductive polymer layer, wherein as conductive polymer those polymers are preferred that have already been mentioned as the preferred conductive polymers in connection with the solar cell according to the present invention. According to a particularly preferred embodiment of the first and the second process according to the present invention the conductive polymer layer prepared in process step III) comprises a polythiophene, preferably a cationic polythiophene that is present in the form of a polythiophene/polymeric anion-complex, wherein those polythiophenes and polymeric anions are preferred that have already been mentioned in connection with the solar cell according to the present invention.

According to a preferred embodiment of the first and the second process according to the present invention at least one of the following conditions A) and B) is fulfilled:
A) in process step III) the treated surface on the back side of the substrate is brought into contact with the layer of a conductive polymer in such a way that the conductive polymer layer is at least partially in direct contact with the surface of the p-type or n-type silicon;
B) the conductive polymer layer comprises a cationic conductive polymer and a polymeric anion in a weight ratio cationic conductive polymer : polymeric anion of greater than 0.4.

According to a first variant of this preferred embodiment of the first and the second process according to the present invention condition A) is fulfilled. According to second variant of this preferred embodiment of the first and the second process according to the present invention condition B) is fulfilled. According to a third variant of this preferred embodiment of the first and the second process according to the present invention conditions A) and B) are fulfilled

It is also preferred in the first and the second process according to the present invention that the conductive polymer layer is formed by applying a liquid composition comprising the conductive polymer and a solvent onto the back side of the substrate and by subsequently removing at least a part of the solvent. Depending on the chemical nature of the conductive polymer and the presence or absence of further compounds such as polymeric anions the liquid composition can be a solution, a dispersion or an emulsion. In the case of a complex of a cationic polythiophene and a polymeric anion, such as a PEDOT/PSS-complex, these complexes are, when being dispersed in water as the solvent, present in the form of swollen gel particles. In the present invention such a system of swollen gel particles in an aqueous system is considered as a dispersion. Suitable solvents are water, lower alcohols such as methanol, ethanol, 1-propanol, 2-propanol or iso-propanol or mixtures of water and one or more of these lower alcohols.

The liquid composition, preferably the dispersion, may further comprise a polymeric anion, wherein preferred polymeric anions are those that have already been mentioned in connection with the solar cell according to the present invention. Particularly preferred liquid compositions are those comprising a polythiophene/polymeric anion complex, in particular solutions, emulsions or dispersions comprising PEDOT/PSS. As stated above, such liquid compositions can be obtained if the monomers on which the polythiophene is based (such as 3,4-ethylenedioxythiophen) are polymerized in the presence of the polymeric anion in an aqueous solution. In this context it may be particularly advantageous to use a liquid composition comprising a cationic conductive polymer, preferably a cationic polythiophene, and a polymeric anion, preferably a polymeric sulfonic acid such as PSS, in a weight ratio cationic conductive polymer : polymeric anion of greater than 0.4, preferably greater than 0.5, more preferably greater than 0.6 and even more preferably greater than 0.65.

The liquid compositions used to prepare the conductive polymer layer can be applied onto the back side of the substrate by known processes, for example by spin-coating, impregnating, casting, drop wise application, spraying, knife-coating, painting or printing, for example inkjet printing, screen printing or pad printing, wherein the method of applying the liquid composition also depends on the structure of the solar cell. If, for example, the solar cell is configured to have both electrodes on the back side of the solar cell and if therefore the layer of the conductive polymer has to be applied in the form of a pattern to only cover selected areas of the back side of the solar cell, techniques such as inkjet printing are preferred.

After the liquid composition has been applied, the solvent is preferably removed for the formation of the conductive polymer layer. Removal of the solvent is preferably achieved by simple evaporation at a drying temperature in the range from 10 to 250°C, preferably 50 to 200°C and more preferably 80 to 150°C for a period of 1 second to 24 hours, preferably 10 seconds to 10 minutes. The thickness of the conductive polymer layer thus applied preferably lies in a range from 1 nm to 10 µm, particularly preferably in a range from 10 nm to 500 nm and most preferably in a range from 20 nm to 200 nm. The surface resistance of the conductive polymer layer thus applied preferably lies in a range from 1 to 5000 Ω/sq, preferably in a range from 10 to 1000 Ω/sq and most preferably in a range from 10 to 250 Ω/sq.

In process step IV) of the first process according to the present invention at least a part of the surface of the conductive polymer layer (i. e. the surface facing away from the back side of the substrate) is covered with an electrode (subsequently referred to as the - first electrode -), wherein for the formation of the electrode in process step IV)
IVa) a conductive metal layer (subsequently referred to as the - first conductive metal layer -) is applied to at least a part of the surface of the conductive polymer layer by means of a conductive adhesive layer, wherein it is preferred that the conductive adhesive layer has a conductivity of not more than 1000 S/cm, more preferably not more than 100 S/cm and even more preferably not more than 10 S/cm;
   or
IVb) a liquid composition comprising conductive metal particles is applied is applied onto at least a part of the surface of the conductive polymer layer, wherein it is preferred that the liquid composition is subsequently hardened, preferably hardened by drying or curing, to form the conductive layer,
wherein the way of covering the conductive polymer layer with the electrode again depends on the structure of the solar cell.
- If the solar cell is configured to have a second electrode at the front side and the first electrode at the back side of the solar cell, it is preferred that almost the entire surface of the back side of the substrate is covered with a conductive polymer layer and that almost the entire surface of the conductive polymer layer is covered with the first conductive metal containing layer (or, in case of alternative IVb), with the conductive layer) serving as the electrode on the back side of the solar cell. In this embodiment the second electrode of the solar cell is applied in the form of a grid of in the form of a pattern comprising at least one metal busbar and metal fingers at the front side of the solar cell.
- If the solar cell is configured to have both electrodes on the back side of the solar cell, the first conductive metal layer (or, in case of alternative IVb), the conductive layer) is only applied onto those areas on the back side of the solar cell which are covered with the conductive polymer layer. The remaining areas (i. e. the n⁺-areas) are covered by a separate metal containing layer.

According to alternative IVa) the electrode is a conductive metal layer that is applied to at least a part of the surface of the conductive polymer layer by means of a conductive adhesive layer, wherein it is preferred that the conductive adhesive layer has a conductivity of not more than 1000 S/cm, more preferably not more than 100 S/cm and even more preferably not more than 10 S/cm. According to a particular preferred embodiment the conductive adhesive layer has conductivity in the range from 1 to 5 S/cm, more preferably 1 to 2 S/cm.

Preferred conductive metal layers and preferred conductive adhesive layers in this context are those metal layers and adhesive layers that have been described above in connection with the solar cell according to the present invention.

The conductive adhesive layer is preferably prepared by means of an adhesive composition that is applied onto at least a part of the surface of the conductive metal layer, onto at least a part of the surface of the conductive polymer layer or onto at least a part of both of these surfaces, wherein the conductive adhesive layer that is obtained after drying and/or curing of the adhesive composition is preferably an electrically conductive adhesive layer having a conductivity as defined above. According to a preferred embodiment of the first process according to the present invention the adhesive composition comprises contains less than 35000 ppm, preferably less than 20000 ppm and even more preferably less than 1000 ppm of nitrogen, in each case based on the total weight of the adhesive composition.

Accordingly, different approaches can be used to cover at least a part of the surface of the conductive polymer layer with the conductive metal layer by means of the electrically conductive adhesive layer:
α1) According to a first approach the adhesive composition that is used for the formation of the electrically conductive adhesive layer (which, as described in connection with the first solar cell according to the present invention, can be a reactive or a non-reactive adhesive and that preferably includes inorganic or organic conductive particles) is applied onto at least a part of the surface of the conductive polymer layer and that conductive metal layer is subsequently attached to the conductive polymer layer that is coated with the adhesive composition, optionally followed by a drying and/or curing step (depending on the nature of the adhesive composition that has been used).
α2) According to a second approach the adhesive composition that is used for the formation of the electrically conductive adhesive layer is applied to the surface of the conductive metal layer and the thus obtained conductive metal layer is subsequently attached to the conductive polymer layer with the side that is covered with the adhesive composition, optionally followed by a drying and/or curing step.
α3) According to a third approach the adhesive composition that is used for the formation of the electrically conductive adhesive layer is applied to both, the surface of the conductive metal layer and the surface of the conductive polymer layer and the conductive metal layer is subsequently attached to the conductive polymer layer with the side that is covered with the adhesive composition, optionally followed by a drying and/or curing step.

In particular in case of non-reactive, pressure sensitives adhesives as described above in connection with the third particular embodiment of the first solar cell according to the present invention, for example pressure sensitive adhesive that are based on a PEDOT/PSS-dispersions comprising a saccharide, such as D-sorbitol, approach α2) is particularly preferred as the adhesive composition is not applied onto the conductive polymer layer and as therefore negative effects of the adhesive composition on the conductive polymer layer, such as a partial solubilization of the conductive polymer layer by means of the solvents in the adhesive composition, can be avoided.

According to a particular embodiment of the first process according to the present invention the electrically conductive adhesive composition that is used in process step IIIa) is an acrylate-based anaerobic adhesive composition.

According to alternative IVb) the electrode is a conductive layer that is prepared by applying a liquid composition comprising conductive metal particles onto at least a part of the surface of the conductive polymer layer, wherein it is preferred that the liquid composition is subsequently hardened, preferably hardened by drying or curing, to form the conductive layer. Preferred conductive metal particles are the inorganic conductive particles that have been previously mentioned in connection with the adhesive layer. In this context it is, however, particularly preferred that the conductive metal particles are not silver particles.

According to a further preferred embodiment of the first and the second process according to the present invention the process comprises a further process step:
VI) covering at least a part of the surface of the conductive polymer layer with a further conductive polymer layer that comprises metal nanowires before step IV).

As stated in connection with the solar cell according to the present invention preferred metal nanowires in this context are silver nanowires. This further conductive layer preferably further comprises particles of a polythiophene/polyanion-complex, in particular PEDOT/PSS-particles. According to a particular preferred embodiment of the process according to the present invention the further conductive layer is a PEDOT/PSS-layer that comprises silver nanowires, wherein the content of silver nanowires in this further conductive layer is preferably in the range from 5 to 95 wt.-%, more preferably in the range from 15 to 70 wt.-%, based on the total weight of the further conductive layer. The thickness of the further conductive layer is preferably in the range from 30 to 1000 nm, more preferably in the range from 60 to 350 nm.

The further conductive layer is preferably prepared by applying dispersion comprising particles of a polythiophene/polyanion-complex and metal nanowires, more preferably a PEDOT/PSS-dispersion comprising silver nanowires, to at least a part of the surface of the conductive polymer layer, followed by a removal of at least a part of the solvent of the PEDOT/PSS-dispersion.

According to a further preferred embodiment of the first process according to the present invention and according to the second process according to the present invention the process comprises a further process step:
V) covering at least a part of the lateral surfaces of the solar cell with a protective film, preferably with a protective polymer film,
wherein preferred protective films are those films that have already been described in connection with the first and the second solar cell according to the present invention. A particular preferred protective film is a layer of an epoxy resin that covers at least a part of the lateral surfaces of the solar.

In this context it is particularly preferred that the protective film is formed by a process comprising the process steps:
Va) optionally applying an adhesive tape onto a least a part of the lateral surfaces of the solar cell, where the tape material is preferably based on a polyolefin such as a polyethylene;
Va) applying a curable composition onto a least a part of the lateral surfaces of the solar cell, or applying a curable composition onto at least a part of the surface of the adhesive tape;
Vb) curing the curable composition to form the protective film.

Preferred curable compositions in this context are UV-curable composition that are cured by UV-light, such as DELO-KATIOBOND^{®} LP 655 obtainable from DELO Industrie Klebstoffe, Windach, Germany.

A contribution to achieving at least one of the above mentioned objects is also made by a solar cell obtainable by the process according to the present invention.

A contribution to achieving at least one of the above mentioned objects is also made by a module comprising at least one solar cell according to the present invention or at least one solar cell obtained by the process according to the present invention, in particular according to at least one of the above described embodiments, and at least one further solar cell, wherein the at least one further solar cell can be a solar cell according to the present invention or a solar cell obtained by the process according to the present invention, or a solar cell of the prior art. A multiplicity of solar cells according to the present invention can be arranged spatially and electrically connected to form a collective arrangement called a module. Preferred modules according to the present invention can take a number of forms, preferably a rectangular surface known as a solar panel. Large varieties of ways to electrically connect solar cells as well as large varieties of ways to mechanically arrange and fix such cells to form collective arrangements are well known to the person skilled in the art and any such methods known to him and which he considers suitable in the context of the present invention can be employed. Preferred methods according to the present invention are those which result in a low mass to power output ratio, low volume to power output ration, and high durability. Aluminium is the preferred material for mechanical fixing of solar cells according to the present invention.

### DESCRIPTION OF THE DRAWINGS

The present invention is now explained by means of figures and examples, wherein the figures are intended for illustration only and are not to be considered as limiting the scope of the present invention. In brief,
Fig. 1 shows a side view of a solar cell 1 according the first particular embodiment of the solar cell according to present invention, wherein a second electrode 6 is localized at the front side 2a and a first electrode 5 is localized at the back side 2b of the substrate 2. The first electrode 5 comprises a metal foil 5b that is attached to a conductive polymer layer 4 by means of a conductive adhesive layer 5a.
Fig. 2 shows a cross sectional view of the solar cell 1 shown in fig. 1.

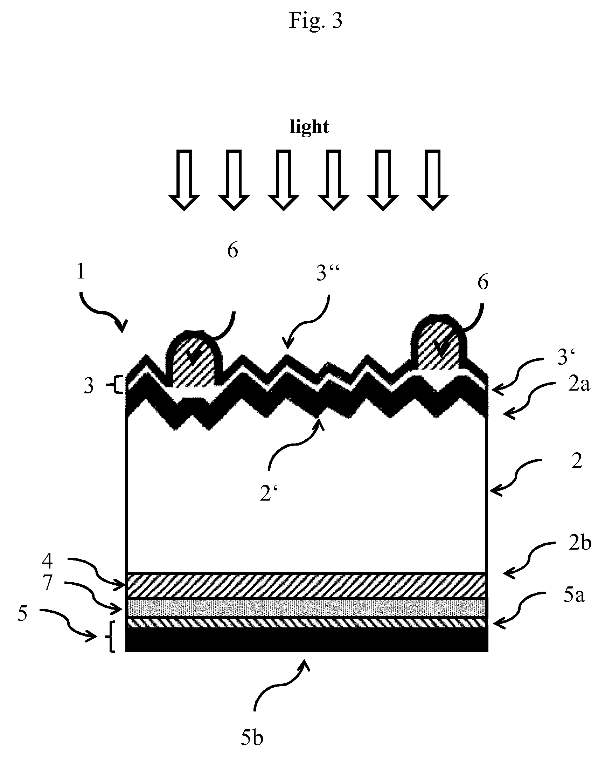

Fig. 3 shows a further cross sectional view of a solar cell according to the present invention, wherein the solar cell comprises a further conductive layer 7 that is localized between the conductive polymer layer 4 and the adhesive layer 5a.

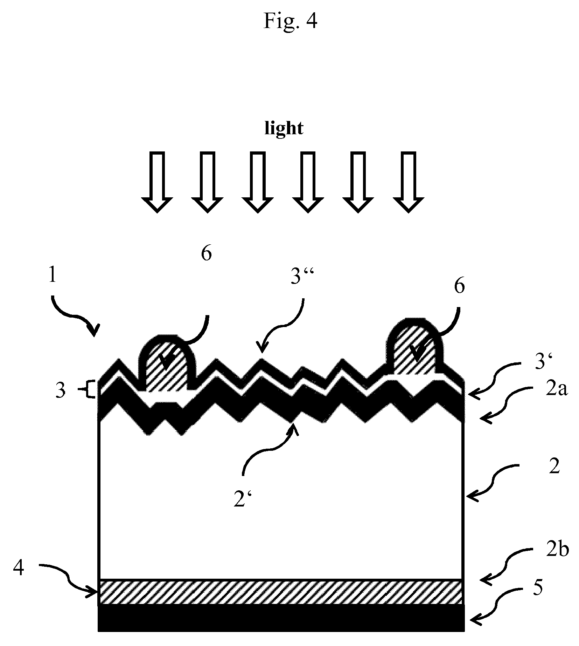

Fig. 4 shows a further cross sectional view of a solar cell according to the present invention, wherein the first electrode has been prepared by applying a liquid composition onto at least a part of the surface of the conductive polymer layer 4 and wherein the liquid composition has subsequently been hardened to form the conductive layer.

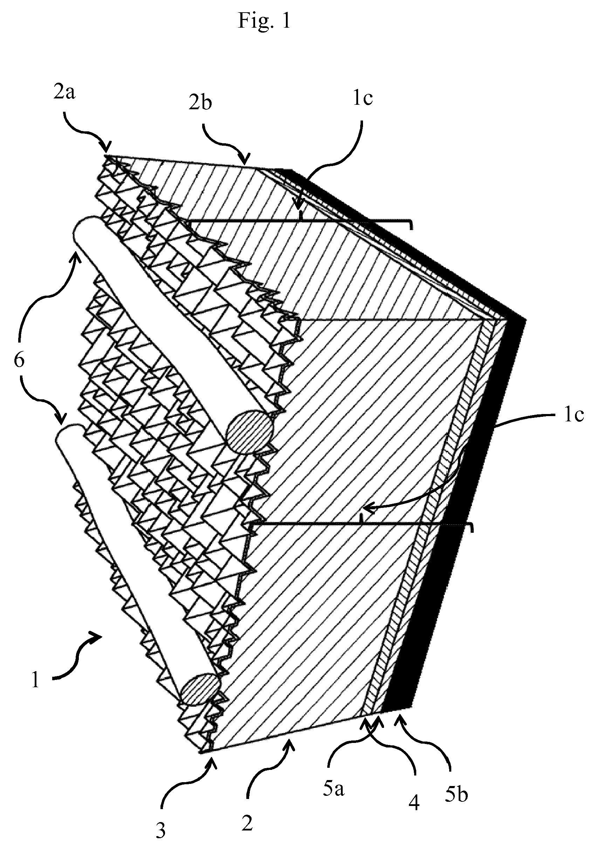

Fig. 5 shows a further cross sectional views of solar cells according to the present invention, wherein the lateral surfaces 1c (as shown in figure 1) of the solar cell are covered by protective film. In Figure 5a the solar cell 1 is attached to a carrier substrate 10, for example an aluminium foil, the size of which is larger than the size of the substrate of the solar cell. The solar cell 1 is attached to the carrier substrate 10 by applying the adhesive tape 9 onto the border area of the front surface of the solar cell 1, onto the lateral surfaces 1c of the solar cell and the onto the carrier substrate 10. Onto the adhesive tape 9 there is applied the protective layer 8. In figure 5b the solar cell 1 is attaches to a carrier substrate 10 the size of which corresponds to the size of the substrate of the solar cell 1. The solar cell 1 is attached to the carrier substrate 10 by applying the adhesive tape 9 onto the border area of the front surface, onto the lateral surface of the solar cell 1 and onto the border surface of the carrier substrate 10 on the side of the carrier substrate that is facing away from the solar cell (see figure 5b). Carrier substrate 10 can also be the first electrode 5b.
Fig. 6 shows the cell degradation of the solar cells obtained in Example 1 and Example 2.
Fig. 7 shows the cell degradation of solar cells 5 and 7 obtained in Example 6.

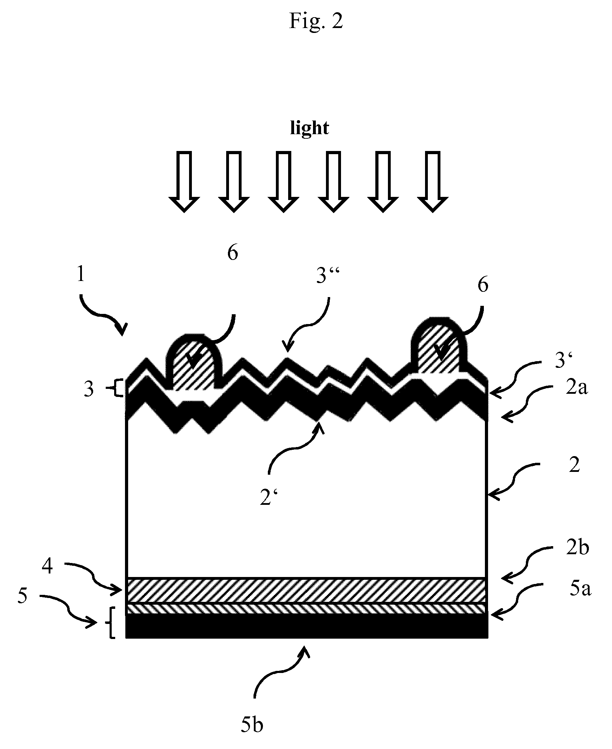

Figures 1 and 2 show a realization form of the solar cell 1 according the first particular embodiment of the present invention, wherein a second electrode 6 is localized at the front side 2a and a first electrode 5 is localized at the back side 2b of the substrate 2. This solar cell structure is characterized by a conventionally processed RP-textured front side 2a that was provided with a phosphorus-diffused electron collecting n⁺-layer 2' (the so called *"n*⁺*-Front Surface Field",* n⁺-FSF). The front side 2a (i. e. the n⁺-FSF) was coated with an Al₂O₃ tunnel layer 3', metallized with aluminum and then passivated with a SiNₓ-layer 3". The front side 2a was made with a standard process developed by the Institute for Solar Energy Research Hamelin (ISFH) and described by D. Zielke et al., "Contact passivation in silicon solar cells using atomic-layer-deposited aluminum oxide layers". Phys. Stat. Sol. RRL 5, 298-300 (2011). On the back side 2b of the solar cell 1 the hole-transporting PEDOT/PSS/c-Si heterojunction is localized. Onto the PEDOT/PSS-layer 4 a metal foil 5b, for example a copper foil, has been applied for the formation of the first electrode 5 by means of an adhesive layer 5a.

For the production of the solar cell 1 as shown in figures 1 and 2 (and as performed in the examples below) a boron-doped (p-type) float-zone (FZ) silicon wafer 2 having a specific resistivity (p) of 0.5 to 1.5 Ωcm and a thickness of 300 µm and phosphor-doped (n-type) Czochralski (Cz) silicon wafer 2 having a specific resistivity of, for example, 1.5 to 5 Ωcm and a (100)-orientation are used as the starting materials. The wafers are cut into 2 × 2 cm probes by means of a laser. The wafers 2 are cleaned with an RCA sequence and protected on both sides with a SiNₓ-layer having a thickness of 100 nm (index of refraction: 1.9 at a wavelength of 632 nm) and being deposited by PECVD. On one side of the passivated silicon wafer 2 (subsequently referred to as the front side) a 2 × 2 cm diffusion window was opened in the SiNₓ layer by laser ablation (frequency-doubled Nd : YVO₄ laser, SuperRapid, Lumera). After cleaning the probes in solutions of H₂O:HCl:H₂O₂ and H₂O:NH₄:H₂O₂ having a temperature of 80°C a random pyramid texture is produced in the opened SiNₓ-windows by means of a KOH/isopropanol solution. During texturing randomly distributed pyramids having a size of about 5 µm are formed on the surface of the silicon while the SiNₓ-layer is not affected. After further RCA-cleaning, phosphorus diffusion is performed in the open and textured SiNₓ window with a POCl₃ source in a quartz tube furnace at 850°C. The resulting n⁺-FSF 2' has a sheet resistance of about 100 Ω/sq at a pore deepness of about 0.4 µm. The SiNₓ protective layer and the phosphorus-silicate glass are completely removed using a 5 % fluoric acid solution that is applied for 1 hour and, after a further RCA-cleaning, the textured side of the wafer 2 is coated with an Al₂O₃ tunnel layer 3' having a thickness of 0.24 nm and being deposited by means of atomic layer deposition. Thereafter, an aluminum grid 7 (serving as the second electrode) with a thickness of 20 µm and a finger pitch of 1 mm is deposited by electron beam evaporation using nickel shadow masks on the textured front side 2a. By means of an aluminium etching solution the aluminium under depositions is removed and the front side 2a is subsequently coated with a passivating SiNₓ layer having a refractive index of 2.4 and at a wavelength of 632 nm and a thickness of 10 nm. Without breaking the vacuum a 70 nm thick SiNₓ anti-reflection layer having a refractive index of 1.9 at a wavelength of 632 Nm was applied. The two SiNₓ layers together are indicated by reference number 3" in figure 2 and are deposited at 330°C by PECVD. After depositing SiNₓ the probes are tempered at 350°C for 2 min under air in order to improve the metal contact at the front side.

Before depositing PEDOT/PSS at the back side the probes are etched for 1 minute in a 1 % aqueous solution of HF. Immediately after this treatment a PEDOT/PSS layer 4 has been applied onto the back side 2b of the probe by spin coating (500 revolutions per minute for 10 seconds, followed by 1000 rpm for 30 seconds) a PEDOT/PSS-dispersion (i. E. dispersions Example 3 as described below) on the untextured side of the cell. The cells are then dried at 130°C for 15 minutes on a hot plate. The resultant PEDOT/PSS layer 4 that has been deposited at the back side 2b of the solar cell 1 has a thickness of about 50 to 400 nm.

Finally, to the surface of the PEDOT/PSS layer 4 the first electrode 5 is applied. For that purpose a metal foil, for example a copper foil, is coated onto one side of the foil with a conductive adhesive, for example a reactive adhesive that comprises inorganic or organic conductive particles. The coated foil is then applied onto the PEDOT/PSS-layer, followed by a drying or pressing and/or curing step (depending on the nature of the adhesive that has been used).

### METHODS AND SUBSTRATES

### Substrates

In the case of p-type silicon a boron doped float zone silicon with a resistivity (p) of 150 Ωcm and a thickness of 300 µm was used. In the case of n-type silicon a phosphorus doped Czochralski (Cz) Silicon with a resistivity (p) of 4 Ωcm and a thickness of 160µm and a (100)-Orientation was used as basis. All wafers were cut into in 2 × 2 cm or 15.6 × 15.6 cm sample size and subjected to RCA cleaning.

### Surface Resistance

The surface resistance of the conductive adhesive layers is determined by applying a defined layer of the conductive glue on a glass substrate, curing and/or drying the layer, coating two fine lines of a silver ink or evaporating two silver electrodes of 2 cm length at a distance of 2 cm on to the polymer layer via a shadow mask. The square region of the layer between the electrodes is then separated electrically from the remainder of the layer by scratching two lines with a scalpel. The surface resistance is measured between the Ag electrodes with the aid of an ohmmeter (Keithley 614).

### Electrical conductivity

The electrical conductivity means the inverse of the specific resistance. The specific resistance is calculated from the product of surface resistance and layer thickness of the conductive polymer layer. The surface resistance is determined for conductive polymers in accordance with DIN EN ISO 3915. In concrete terms, the polymer to be investigated is applied as a homogeneous film by means of a spin coater to a glass substrate 50 mm × 50 mm in size thoroughly cleaned. In this procedure, the coating composition was applied onto the electrode by means of a pipette to completely cover the area. Excess dispersion was spun off. Films are dried at 130°C for 15 min. This leads to a 50 - 150 nm thick homogenous layer for all materials. In all cases silver electrodes of 2.0 cm length at a distance of 2.0 cm are vapour-deposited on to the polymer layer via a shadow mask. The square region of the layer between the electrodes is then separated electrically from the remainder of the layer by scratching two lines with a scalpel. The surface resistance is measured between the Ag electrodes with the aid of an ohm25 meter (Keithley 614). The thickness of the polymer layer is determined with the aid of a Stylus Profilometer (Dektac 150, Veeco) at the places scratched away.

### Efficiency, J_{SC}, V_{OC} and FF

The sample solar cells are characterized using a commercial IV-tester "cetisPV-CTL1" from Halm Elektronik GmbH. All parts of the measurement equipment as well as the solar cell to be tested were maintained at 25 °C during electrical measurement. This temperature is always measured simultaneously on the cell surface during the actual measurement by a temperature probe. The Xe Arc lamp simulates the sunlight with a known AM1.5 intensity of 1000 W/m² on the cell surface. To bring the simulator to this intensity, the lamp is flashed several times within a short period of time until it reaches a stable level monitored by the "PVCTControl 4.313.0" software of the IV-tester. The Halm IV tester uses a multi-point contact method to measure current (I) and voltage (V) to determine the cell's IV-curve. To do so, the solar cell is placed between the multi-point contact probes in such a way that the probe fingers are in contact with the bus bars of the cell. The numbers of contact probe lines are adjusted to the number of bus bars on the cell surface. All electrical values were determined directly from this curve automatically by the implemented software package. As a reference standard a calibrated solar cell from ISE Freiburg consisting of the same area dimensions, same wafer material and processed using the same front side layout is tested and the data compared to the certificated values. At least 5 wafers processed in the very same way are measured and the data interpreted by calculating the average of each value. The software PVCTControl 4.313.0 provides values for efficiency, fill factor (FF), short circuit current (J_{SC}) and open circuit voltage (V_{OC}).

### EXAMPLES

### Example 1 (comparative example of a 2 × 2 cm cell with PEDOT/PSS without encapsulation)

p-type wafers were used. One side of the wafer was coated with an Al₂O₃ tunnel layer, metallized with aluminum and then passivated with a 100 nm SiNₓ-layer (refractive index 2.4 at 632 nm wavelength) that was deposited via plasma enhanced chemical vapor deposition (PECVD). This side will be referred to as front side. The deposition temperature was 400°C and the time 5 min. After SiNₓ Deposition the sample was placed into a 1% HF solution in order to remove any undefined SiOx Layer on back side that may have been generated during PECVD deposition.

PEDOT/PSS was deposited by spin-coating on the back side at 500 rpm for 10 seconds and subsequently 1000 rpm for 30 seconds. The sample was then dried on a hotplate in air at 130°C for 15 min. The thickness of the conductive PEDOT/PSS-layer is in the range between 50 and 200 nm. Finally, the entire rear surface was metallized by electron beam evaporated silver.

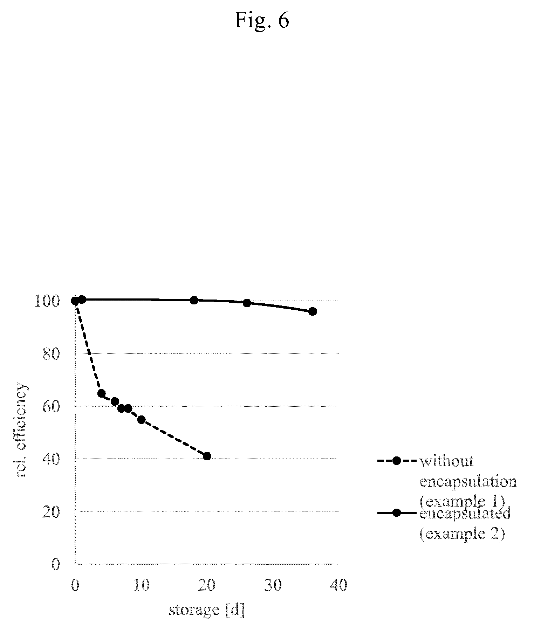

Cells were stored under ambient conditions and measured after defined storage periods. The results are summarized in figure 6, showing a fast degradation of the cell.

### Example 2 (inventive example of a 2 × 2 cm cell with PEDOT/PSS with encapsulation)

The procedure of example 1 was repeated. After the metallization of the rear side by electron beam evaporated silver, the cell was glued onto a titanium passivated aluminium foil or a silver foil (25 µm, 99,95 % metals basis, Alfa Aesar, Karlsruhe Germany) with an adhesive PE tape (TESA). The edges of the adhesive tape were sealed with UV-curable glue (DELO, Katiobond LP 655) to prevent water penetration. The UV-curable glue was cured using a Beltrostat (Beltron GmbH, Rödermark Germany) with an UVH-Source, curing was conducted 3 times for 50 seconds at maximum output. (per 50 second dose of 2451 - 2552 mJ/cm²). Cells were stored under ambient conditions and measured after defined storage periods. The results are summarized in figure 6, showing a slow degradation of the cell.

### Example 3 (inventive example of a 15.6 × 15.6 cm cell with PEDOT/PSS + Ag adhesive + copper foil)

Commercial cz-fullsquare mono cell precursors with a p-basis were used, where the emitter and SiNₓ as antireflective coating were implemented already. Front side grid was printed using a silver paste (SOL 9621 M, Heraeus, Hanau Germany) and fired. Prior to PEDOT/PSS deposition by slot-die coating on the back side (Table Coater, TSE Troller AG, Murgenthal Switzerland) silicium oxide was removed by floating on HF (2.33%, VLSI grade) for 5 min.

The composition of the PEDOT/PSS-dispersion was as follows:

**Table 1: composition of PEDOT/PSS-dispersion**

| substance | amount | weight percent in formulation [%] |
|---|---|---|
| PEDOT/PSS (40 % PEDOT) | 720.0 g | 44.9 |
| water | 720.0 g | 44.9 |
| DMSO | 75.9 g | 4.8 |
| surfactant 1 | 1.5 g | 0.1 |
| isopropanol | 1.5 g | 0.1 |
| n-propanol | 75.6 g | 4.8 |
| crosslinker | 6.4 g | 0.4 |
| surfactant 2 | 1200 µl | 0.08 |

The PEDOT/PSS-passivation layer was dried for 10 min in a convection oven.

Different silver filled electrically conductive adhesives (ECA) were applied by a handcoater (24 µm, handcoater Erichsen, Germany) onto a metal foil for mounting on the back side. The ECA-coated metal foil (copper, 10 µm, Schlenk, Roth-Barnsdorf, Germany) was brought into contact with the passivation layer and ECA was cured on a hot plate. The following table shows a selection of ECA tested with curing procedure.

**Table 2: adhesives that have been used and curding conditions**

| ECA | Conductivity of adhesive layer [S/cm] | cell number | curing conditions | metal foil |
|---|---|---|---|---|
| Delo IC343 | 7140 | 3 | 120 °C / 10 min | Cu |
| Delo DA 375 | 10000 | 4 | 120°C/20min | Cu |

Cell-Performance was measured on a cetisPV-Celltest3 (h.a.l.m. Elektronik GmbH, Frankfurt, Germany).

**Table 3: determination of open circuit voltage (V_{OC}), short circuit current density (J_{SC}), Fill Factor (FF) and efficiency**

| cell number | efficiency [%] | Voc [V] | Jsc [mA/cm2] | FF [%] |
|---|---|---|---|---|
| 3 | 1.75 | 0.591 | 18.15 | 16.27 |
| 4 | 2.16 | 0.606 | 10.89 | 32.73 |

### Example 4 (inventive example of a 15.6 × 15.6 cm cell with PEDOT/PSS + wire adhesive + copper foil)

Preparation of cells was conducted in accordance with example 3, with the difference that a 60 µm wet film of a wire adhesive (Anders Products, Division of Idolon Technologies, Andover MA, United States of America) was used for mounting the metallization foil (copper) on the back side. The metal foil was perforated with a needle. The adhesive layer was dried for 10 min at 120 °C. The conductivity of the adhesive layer was 1-2 S/cm. The cell is labeled cell number 5.

### Example 5 (comparative example of a 15.6 × 15.6 cm cell with wire adhesive + copper foil, without PEDOT/PSS)

Preparation of cells was conducted in accordance with example 5, with the difference that no PEDOT/PSS-passivation layer was deposited on the silicium surface. The metal foil coated with the 60 µm wet film of the wire adhesive was directly applied to the silicium surface. The adhesive layer was dried for 10 min on a hot plate. The cell is labeled cell number 6.

### Example 6 (inventive example of a 15.6 × 15.6 cm cell with PEDOT/PSS + PEDOT/PSS/AgNW + "Wire glue" + copper foil)

Preparation of cells was conducted in accordance with example 5, with the difference that a passivation layer of PEDOT/PSS was applied by slot-die-coating. A layer of PEDOT/PSS comprising silver nanowires (AgNW) was coated by a handcoater on top of the PEDOT/PSS-passivation layer.
- Composition of PEDOT/PSS AgNW mixture:
61.15 g AgNW (2.195 g silver content) in water were mixt with 61.15 g Clevios PH 1000 (Heraeus Deutschland GmbH & Co.KG, Leverkusen, Germany), 5.67 g DMSO, 373 µL surfactant 2 (Tergitol TMN6) and 0.53 g crosslinker (Wetlink 78). The cell is labeled cell number 7.

**Table 4: determination of open circuit voltage (V_{OC}), short circuit current density (J_{SC}), Fill Factor (FF) and efficiency**

| cell number | efficiency [%] | V_{OC} [V] | J_{SC} [mA/cm2] | FF [%] |
|---|---|---|---|---|
| 5 | 12.50 | 0.607 | 35.38 | 58.23 |
| 6 | 5.44 | 0.596 | 24.68 | 36.95 |
| 7 | 15.30 | 0.609 | 36.46 | 68.87 |

### - Aging of cells number 5 and 7

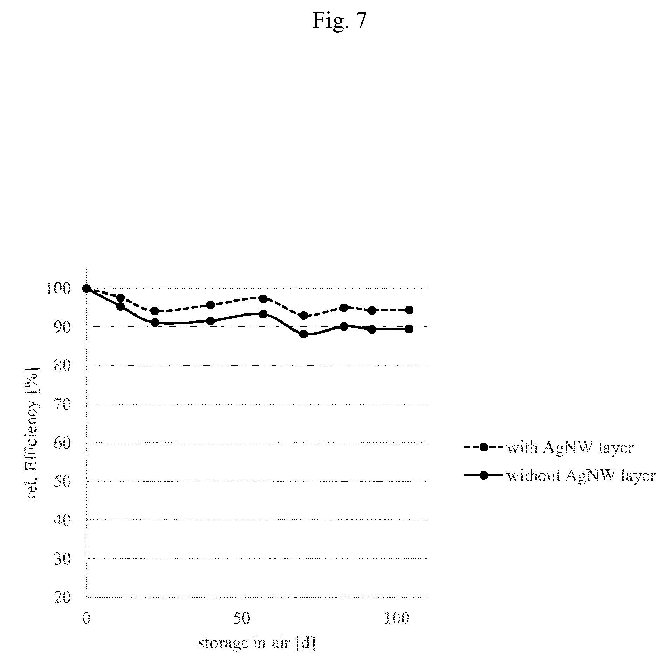

Cells number 5 and 7 were stored under ambient conditions and cell-performance was measured after certain time of storage. Surprisingly it was found, that the cells were much more stable in turns of degradation than a cell prepared in Example 1 that was metallized by evaporated silver. Figure 7 shows the observation for 104 days. Cells number 5 and 7 are called "without AgNW" and "with AgNW" respectively in the diagram.

### Example 7 (inventive example of a 15.6 × 15.6 cm cell with a back side electrode prepared by means of a conductive varnish)

A mixture of 100 g Neocryl B725 (DSM Coating resins, Heerlen, Netherlands), 250 g eConduct Copper 421000 (Eckart, Hartenstein, Deutschland), 75 g butyl acetate (85%), 75 g isopropanol, 143 ethanol and 143 g ethyl acetate was produced. Thin films (100 µm wet film thickness) were applied onto a substrate. After drying at 80 °C hard and conductive coatings with a surface resistance of 1.5 Ω/sq were obtained.

Cells were prepared in accordance with example 3, with the difference that for the preparation of the back side electrode 100 µm of the conductive varnish were applied instead of the metal foil coated with the conductive adhesive. The cell is labeled cell number 8.

**Table 5: determination of open circuit voltage (V_{OC}), short circuit current density (J_{SC}), Fill Factor (FF) and efficiency**

| cell number | efficiency [%] | V_{OC} [V] | J_{SC} [mA/cm2] | FF [%] |
|---|---|---|---|---|
| 8 | 10.35 | 0.592 | 36.29 | 48.19 |

### Example 8 (inventive example of a 15.6 × 15.6 cm cell with PEDOT/PSS + saccharide-containing adhesive + copper foil)

8.4 g D-sorbitol (pure, Applichem, Darmstadt) were dissolved in 100 mL PEDOT:PSS dispersion (Clevios PH 750 HS, Heraeus Deutschland GmbH&Co.KG, Leverkusen, 2.2 % solid content, 2.2 g PEDOT:PSS), optionally a low amount of surfactant was added. Thin layers of the obtained pressure-sensitive adhesive was/were coated onto the copper foil. Application of the adhesive was performed by wire bar coating using a 80 µm wet-film handcoater (Erichsen, Germany). The wet layer was dried at 120 °C for at least 4 minutes. The coated metal foil was then attached to the wafer which was previously coated by a PEDOT/PSS passivation layer by applying pressure to the joint. The lateral conductivity of the adhesive PEDOT/PSS-material material was determined to be 318 S/cm.

Cells were prepared in accordance with example 3, with the difference that the pressure sensitive adhesive based on PEDOT/PSS/sorbitol was used instead of the Ag-filled adhesive. The cell is labeled cell number 9.

### Example 9 (inventive example of a 15.6 × 15.6 cm cell with PEDOT/PSS + anaerobic adhesive + copper foil)

55 mg saccharine (0.3 mmol, Sigma Aldrich, Steinheim Germany) were dissolved in 4.88 g Di(ethylene glycol)dimethacrylate (15.1 mmol, 95% purity, Sigma Aldrich, Steinheim Germany). Subsequently 47.7 mg Luperox A 75 (0.15 mmol, 75% benzoyl peroxide, Sigma Aldrich, Steinheim Germany) and 8.2 µL triethylamine were added, forming an anaerobic curing adhesive.

Cells were prepared in accordance with example 6, with the difference that instead of the carbon-filled adhesive a thin layer of the anaerobic adhesive was coated on the copper foil and was attached to the AgNW layer on the cell by applying pressure and RT for 2 h. The cell is labeled cell number 10.

**Table 5: determination of open circuit voltage (V_{OC}), short circuit current density (J_{SC}), Fill Factor (FF) and efficiency**

| cell number | efficiency [%] | V_{OC} [V] | J_{SC} [mA/cm²] | FF [%] |
|---|---|---|---|---|
| 9 | 14.17 | 0.598 | 34.98 | 67.74 |
| 10 | 4.20 | 0.614 | 32.40 | 21.11 |

### LIST OF REFERENCE NUMBERS

- 1.: solar cell
- 1c: lateral surface of solar cell 1
- 2: substrate (i. e. n-type or p-type Si wafer, preferably n-doped c-Si)
- 2': n⁺-region
- 2a: front side
- 2b: back side
- 3: passivation layer
- 3': Al₂O₃ layer or SiO₂ layer
- 3": SiNₓ layer
- 4: conductive polymer layer (preferably a PEDOT/PSS layer)
- 5: first electrode
- 5a: adhesive layer
- 5b: metal containing layer
- 6: second electrode
- 7: further conductive layer
- 8: protective film
- 9: adhesive tape
- 10: carrier substrate (or first electrode 5)

## Claims

1. A solar cell (1) at least comprising
i) a substrate (2) of p-type silicon or n-type silicon, wherein the substrate (2) comprises a front side (2a) the surface of which is at least partially covered with at least one passivation layer (3) and a back side (2b);
ii) a conductive polymer layer (4) that at least partially covers the back side (2b) of the substrate (2);
iii) an electrode (5) that at least partially covers the conductive polymer layer (4) on the side of the conductive polymer layer (4) that is facing away from the substrate (5);
wherein the electrode (5)
iiia) is a conductive metal layer (5b) that is attached to at least a part of the surface of the conductive polymer layer (4) by means of a conductive adhesive layer (5a); or
iiib) is a conductive layer (5) that has been prepared by applying a liquid composition comprising conductive metal particles onto at least a part of the surface of the conductive polymer layer (4).

2. A solar cell (1) at least comprising
i) a substrate (2) of p-type silicon or n-type silicon, wherein the substrate (2) comprises a front side (2a) the surface of which is at least partially covered with at least one passivation layer (3) and a back side (2b);
ii) a conductive polymer layer (4) that at least partially covers the back side (2b) of the substrate (2);
iii) an electrode (5) that at least partially covers the conductive polymer layer (4) on the side of the conductive polymer layer (4) that is facing away from the substrate (5);
wherein at least a part of the lateral surfaces (1c) of the solar cell (1) is covered by protective film (8).

3. The solar cell (1) according to claim 1, wherein the conductive metal layer (5b) is a surface passivated metal foil.

4. The solar cell (1) according to claim 1 or 3, wherein the conductive adhesive layer (5a) has a conductivity of not more than 1000 S/cm.

5. The solar cell (1) according to anyone claim 1, 3 and 4, wherein the conductive adhesive layer (5a) comprises less than 35000 ppm of nitrogen, based on the total weight of the adhesive layer (5a).

6. The solar cell (1) according to anyone of claims 1 and 3 to 5, wherein the solar cell comprises a further conductive layer (7) that comprises metal nanowires, wherein the further conductive layer (7) is a PEDOT/PSS-layer that comprises silver nanowires and that is arranged between the conductive polymer layer (4) that at least partially covers the back side (2b) of the substrate (2), and the adhesive layer (5 a).

7. The solar cell according to claim 2, wherein a layer of an adhesive polymer tape (9) is arranged between the lateral surfaces (1c) of the solar cell (1) and the protective film (8).

8. A process for the preperation of a solar cell (1) comprising the process steps:
I) providing a substrate (2) of p-type silicon or n-type silicon, wherein the substrate (2) comprises a front side (2a) and a back side (2b);
II) optionally treatment of the back side (2b) with an etching agent;
III) covering at least a part of the optionally treated surface on the back side (2b) of the substrate with a layer of a conductive polymer (4);
IV) covering at least a part of the surface of the conductive polymer layer (4) with an electrode (5); wherein for the formation of the electrode (5) in process step IV)
IVa) a conductive metal layer (5b) is applied to at least a part of the surface of the conductive polymer layer (4) by means of a conductive adhesive layer (5a); or
IVb) a liquid composition comprising conductive metal particles is applied onto at least a part of the surface of the conductive polymer layer (4).

9. A process for the preperation of a solar cell (1) comprising the process steps:
I) providing a substrate (2) of p-type silicon or n-type silicon, wherein the substrate (2) comprises a front side (2a) and a back side (2b);
II) optionally treatment of the back side (2b) with an etching agent;
III) covering at least a part of the optionally treated surface on the back side (2b) of the substrate with a layer of a conductive polymer (4);
IV) covering at least a part of the surface of the conductive polymer layer (4) with an electrode (5);
V) covering at least a part of the lateral surfaces (1c) of the solar cell (1) with a protective film (8), wherein step V) comprises the steps:
Va) optionally applying an adhesive tape (9) onto a least a part of the lateral surfaces (1c) of the solar cell (1), where the tape material is preferably based on a polyolefin;
Vb) applying a curable composition onto a least a part of the lateral surfaces (1c) of the solar cell (1), or applying a curable composition onto at least a part of the surface of the adhesive tape (9);
Vc) curing the curable composition to form the protective film (8).

10. The process according to claim 8, wherein the conductive metal layer (5b) is a surface passivated metal foil.

11. The process according to anyone of claims 8 and 10, wherein the conductive adhesive layer (5a) is prepared by means of an adhesive composition that is applied onto at least a part of the surface of the conductive metal layer (5b), onto at least a part of the surface of the conductive polymer layer (4) or onto at least a part of both of these surfaces, wherein the adhesive layer (5a) obtained after drying and/or curing of the adhesive composition has a conductivity of not more than 1000 S/cm.

12. The process according to claim 11, wherein the adhesive composition comprises less than 35,000 ppm of nitrogen in the form of a basic amine, based on the total weight of the adhesive composition.

13. The process according to claim 9, wherein step V) comprises the steps:
Va) optionally applying an adhesive tape (9) onto a least a part of the lateral surfaces (1c) of the solar cell, where the tape material is preferably based on a polyolefin;
Vb) applying a curable composition onto a least a part of the lateral surfaces (1c) of the solar cell (1), or optionally onto at least a part of the surface of the adhesive tape (9);
Vc) curing the curable composition to form the protective film (8).

14. Solar cell (1), obtainable by the process according to anyone of claims 8 to 13.

15. A solar module, comprising at least one solar cell (1) according to anyone of claims 1 to 7 and 14 and at least one further solar cell.
